(19) Europäisches Patentamt / European Patent Office / Office européen des brevets

(11) **EP 4 191 853 B1**

(12) **FASCICULE DE BREVET EUROPEEN**

(45) Date de publication et mention de la délivrance du brevet:
**03.09.2025 Bulletin 2025/36**

(21) Numéro de dépôt: **22211441.5**

(22) Date de dépôt: **05.12.2022**

(51) Classification Internationale des Brevets (IPC):
*H02M 1/00* (2006.01)   *H02M 1/088* (2006.01)
*H02M 3/00* (2006.01)   *H02M 3/335* (2006.01)

(52) Classification Coopérative des Brevets (CPC):
**H02M 3/33573; H02M 1/0058; H02M 3/01;
H02M 3/33561; H02M 3/33584;** Y02B 70/10

(54) **CONVERTISSEUR D ÉNERGIE ÉLECTRIQUE AVEC AU MOINS UN COUPLE D ENSEMBLES PIÉZOÉLECTRIQUES ET AU MOINS UN INTERRUPTEUR COMPLÉMENTAIRE DE CONNEXION DIRECTE ENTRE EUX, SYSTÈME DE CONVERSION ET PROCÉDÉ DE PILOTAGE ASSOCIÉS**

ELEKTRISCHER ENERGIEWANDLER MIT MINDESTENS EINEM PAAR PIEZOELEKTRISCHER ANORDNUNGEN UND MINDESTENS EINEM KOMPLEMENTÄREN DIREKTVERBINDUNGSSCHALTER, UMWANDLUNGSSYSTEM UND STEUERUNGSVERFAHREN DAFÜR

ELECTRIC ENERGY CONVERTER WITH AT LEAST ONE PAIR OF PIEZOELECTRIC ASSEMBLIES AND AT LEAST ONE DIRECT CONNECTION COMPLEMENTARY SWITCH, ASSOCIATED CONVERSION SYSTEM AND CONTROL METHOD

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **03.12.2021 FR 2112933**

(43) Date de publication de la demande:
**07.06.2023 Bulletin 2023/23**

(73) Titulaire: **Commissariat à l'Energie Atomique et aux Energies Alternatives
75015 Paris (FR)**

(72) Inventeurs:
• **DESPESSE, Ghislain
38054 Grenoble Cedex 9 (FR)**
• **TOUHAMI, Mustapha
38054 Grenoble Cedex 9 (FR)**
• **BRETON, Valentin
38054 Grenoble Cedex 9 (FR)**

(74) Mandataire: **Lavoix
2, place d'Estienne d'Orves
75441 Paris Cedex 09 (FR)**

(56) Documents cités:
CN-A- 102 522 492     US-A1- 2013 169 198
US-A1- 2017 012 556

• POLLET BENJAMIN: "Convertisseurs DC-DC électrique avec stockage provisoire d'énergie sous forme mécanique", 15 November 2019 (2019-11-15), pages 1 - 169, XP055862319, Retrieved from the Internet <URL:https://tel.archives-ouvertes.fr/tel-02415837/document> [retrieved on 20211116]

## Description

### DOMAINE

La présente invention concerne un convertisseur d'énergie électrique apte à convertir une tension d'entrée en au moins une tension de sortie, et comprenant au moins un couple de premier et deuxième ensembles piézoélectriques, chaque ensemble piézoélectrique comportant au moins un élément piézoélectrique ; un premier pont de commutation comportant deux premières branches de commutation, chaque première branche de commutation comportant au moins un premier interrupteur ; au moins un deuxième pont de commutation comportant deux deuxièmes branches de commutation, chaque deuxième branche de commutation comportant au moins un deuxième interrupteur ; chaque ensemble piézoélectrique comportant une première extrémité connectée au premier pont de commutation et une deuxième extrémité connectée au deuxième pont de commutation ; chaque premier interrupteur étant connecté entre une borne d'application de la tension d'entrée et une première extrémité respectives ; et chaque deuxième interrupteur étant connecté entre une borne de fourniture de la tension de sortie et une deuxième extrémité respectives.

L'invention concerne également un système électronique de conversion d'énergie électrique comprenant un tel convertisseur d'énergie électrique et un dispositif électronique de pilotage dudit convertisseur.

L'invention concerne aussi un procédé de pilotage d'un tel convertisseur d'énergie électrique.

L'invention concerne le domaine des systèmes électroniques de conversion d'énergie électrique, en particulier ceux comportant un élément piézoélectrique, notamment des systèmes de conversion en une énergie électrique continue, c'est-à-dire les systèmes de conversion continu-continu, également appelés systèmes de conversion DC-DC (de l'anglais *Direct Current - Direct Current*), et les systèmes de conversion alternatif-continu, également appelés systèmes de conversion AC-DC (de l'anglais *Alternating Current - Direct Current).*

### ARRIERE-PLAN

US 2017/012556 A1 concerne un circuit de conversion de puissance comprenant un onduleur, une unité de transformation piézoélectrique comprenant des transformateurs piézoélectriques connectés en parallèle à une borne de sortie de l'onduleur.

US 2013/169198 A1 décrit un circuit de commande piézoélectrique à commutation de tension nulle comprenant un circuit de commande en demi-pont, un élément piézoélectrique, et au moins un circuit de dérivation.

CN 102 522 492 A décrit un coupleur piézoélectrique et son circuit de puissance. Ils sont principalement utilisés lorsqu'il est nécessaire d'isoler l'entrée et la sortie dans une alimentation à commutation de faible puissance.

On connait des documents FR 3 086 471 A1 et FR 3 086 472 A1, ainsi que du manuscrit de thèse « Convertisseurs DC-DC piézoélectrique avec stockage provisoire d'énergie sous forme mécanique » de Benjamin POLLET, un convertisseur d'énergie électrique du type précité, visible sur la figure 20 des documents FR 3 086 471 A1 et FR 3 086 472 A1, et sur la figure 4.15 du manuscrit de thèse précité.

Les interrupteurs des premier et deuxième ponts de commutation sont commandés de façon cyclique, à la fréquence principale d'oscillation des ensembles piézoélectriques autour de leur mode de résonance présélectionné avec, entre chaque fermeture d'interrupteur(s), une phase dans laquelle les ensembles piézoélectriques sont en circuit ouvert via l'ouverture d'au moins un interrupteur. La fermeture de chaque interrupteur s'effectue avantageusement sous une tension approximativement nulle à ses bornes, et dans tous les cas, la fermeture d'un interrupteur n'engendre jamais une variation importante de tension aux bornes du ou des ensembles piézoélectriques (inférieure à 20%, et avantageusement inférieure à 10%, de la tension d'entrée $V_{in}$ ou de la tension de sortie $V_{out}$).

En régime établi, un cycle de commande comporte typiquement six phases distinctes successives, à savoir trois phases à tension sensiblement constante aux bornes de chaque élément piézoélectrique et trois phases à charge sensiblement constante aux bornes dudit élément piézoélectrique, avec une alternance entre phases à tension sensiblement constante et phases à charge sensiblement constante.

Comme indiqué dans le document FR 3 086 471 A1 ou encore dans le manuscrit de thèse, un avantage qu'il y a à utiliser deux éléments piézoélectriques est que la tension de sortie est ainsi isolée de la tension d'entrée, sans pour autant qu'il soit nécessaire d'utiliser un transformateur.

L'isolation est capacitive et ne se fait donc pas avec un transformateur qui est source de pertes, mais par le fait que l'impédance du résonateur piézoélectrique est très élevée en basse fréquence et bloque toute propagation de la tension à basse fréquence de l'entrée vers la sortie, et inversement. En outre, la composante éventuelle de mode commun d'entrée égale à la moitié de la somme des potentiels en les bornes de fourniture de la tension d'entrée ne se répercute pas sur la composante de mode commun de sortie égale à la moitié de la somme des potentiels en les bornes d'application de la tension de sortie et inversement. Les potentiels ou composantes de modes commun d'entrée et de sortie peuvent ainsi évoluer librement, en basse fréquence, l'un par rapport à l'autre. En effet, chaque élément piézoélectrique est modélisé sous forme d'un condensateur et d'une branche résonante connectée en parallèle du condensateur, la capacité dudit

EP 4 191 853 B1

condensateur étant appelée capacité parallèle, ou encore capacité de référence, et notée $C_0$. Un signal basse fréquence de type 50/60 Hz sera alors filtré par la haute impédance (par exemple 3,1 MΩ pour $C_0$ = 1 nF à 50 Hz) de chacune des capacités bloquées des deux résonateurs piézoélectriques créant ainsi une isolation entre les parties entrées et sortie du convertisseur.

Cet avantage est présent même par rapport à un transformateur piézoélectrique, dans lequel toute l'énergie apportée au primaire n'est pas complètement transmise au secondaire et le primaire doit par ailleurs mettre en mouvement une masse plus grande, à savoir celle du primaire plus celle du secondaire, ce qui engendre des pertes.

Toutefois, le fonctionnement d'un tel convertisseur n'est pas optimal autour de la fréquence de résonance des éléments piézoélectriques.

## RESUME

Le but de l'invention est alors de proposer un convertisseur d'énergie électrique comportant au moins deux ensembles piézoélectriques, et un procédé de pilotage associé, permettant un pilotage amélioré du convertisseur, notamment avec davantage de valeurs de tension possibles lors d'une phase respective à tension sensiblement constante.

A cet effet, l'invention a pour objet un convertisseur d'énergie électrique, selon la revendication 1.

Avec le convertisseur d'énergie électrique selon l'invention, l'interrupteur complémentaire permet de connecter directement entre elles les premières extrémités d'un couple respectif de premier et deuxième ensembles piézoélectriques et de forcer alors à la valeur nulle la tension entre ces premières extrémités, ou bien de connecter directement entre elles les deuxièmes extrémités dudit couple d'ensembles piézoélectriques et de forcer alors la tension entre ces deuxièmes extrémités à la valeur nulle. L'interrupteur complémentaire permet alors d'offrir des valeurs additionnelles possibles pour la tension piézoélectrique totale aux bornes du couple d'ensembles piézoélectriques, indépendamment de l'état, passant ou ouvert, des interrupteurs des branches de commutation, connectés entre ces extrémités du couple d'ensembles piézoélectriques et les bornes d'application de la tension d'entrée ou de fourniture de la tension de sortie.

Autrement dit, le convertisseur d'énergie électrique selon l'invention offre un pilotage amélioré, tout en autorisant en outre une commande des interrupteurs des branches de commutation permettant bien de transférer de la puissance de l'entrée vers la sortie, mais sans injecter de composante de mode commun.

Durant les phases à tension sensiblement constante aux bornes des ensembles piézoélectriques, la tension aux bornes des ensembles piézoélectriques ne varie pas et ne peut pas induire une tension de mode commun haute fréquence.

De préférence, durant les phases à charge sensiblement constante aux bornes desdits ensembles piézoélectriques, la position fermée d'au plus un interrupteur respectif parmi les interrupteurs connectés directement au premier ensemble piézoélectrique et d'au plus un interrupteur respectif parmi les interrupteurs connectés directement au deuxième ensemble piézoélectrique en même temps, tous les autres interrupteurs des premières et deuxièmes branches de commutation étant en position ouverte, permet d'éviter la connexion de l'un ou l'autre des ensembles piézoélectriques entre un potentiel de la tension d'entrée et un potentiel de la tension de sortie, et alors d'éviter l'introduction d'une composante de mode commun haute fréquence entre la tension d'entrée et la tension de sortie.

En outre, dans des configurations très élévateur et très abaisseur, les premières branches de commutation comportent de préférence un seul premier interrupteur, ou bien les deuxièmes branches de commutation comportent de préférence un seul deuxième interrupteur, ce qui permet d'économiser deux interrupteurs par rapport aux configurations très élévateur et très abaisseur du convertisseur de l'état de la technique avec deux ponts en H, tel que celui visible sur la figure 20 des documents FR 3 086 471 A1 et FR 3 086 472 A1, et sur la figure 4.15 du manuscrit de thèse précité.

Suivant d'autres aspects avantageux de l'invention, le convertisseur d'énergie électrique est selon l'une quelconque des revendications 2 à 6.

L'invention a aussi pour objet un système électronique de conversion d'énergie électrique, selon la revendication 7.

Suivant d'autres aspects avantageux de l'invention, le système électronique de conversion d'énergie électrique est selon l'une quelconque des revendications 8 à 12.

L'invention a également pour objet un procédé de pilotage d'un convertisseur d'énergie électrique, selon la revendication 13 ou 14.

## BREVE DESCRIPTION DES DESSINS

Ces caractéristiques et avantages de l'invention apparaîtront plus clairement à la lecture de la description qui va suivre, donnée uniquement à titre d'exemple non limitatif, et faite en référence aux dessins annexés, sur lesquels :

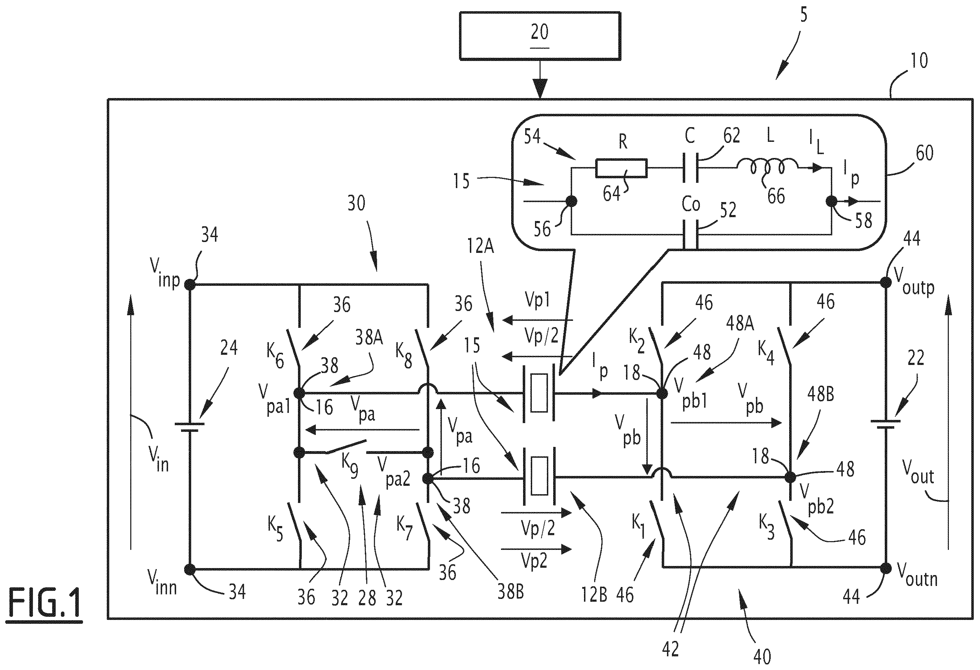

- la figure 1 est une représentation schématique d'un système électronique de conversion d'énergie électrique selon

3

l'invention, comprenant un convertisseur d'énergie électrique et un dispositif électronique de pilotage dudit convertisseur, le convertisseur comportant un couple de premier et deuxième ensembles piézoélectriques, un premier pont de commutation comportant deux premières branches de commutation, chaque première branche de commutation comportant deux premiers interrupteurs, un deuxième pont de commutation comportant deux deuxièmes branches de commutation, chaque deuxième branche de commutation comportant deux deuxièmes interrupteurs, chaque ensemble piézoélectrique comportant une première extrémité connectée au premier pont de commutation et une deuxième extrémité connectée au deuxième pont de commutation, chaque premier interrupteur étant connecté entre une borne d'application de la tension d'entrée et une première extrémité respectives, chaque deuxième interrupteur étant connecté entre une borne de fourniture de la tension de sortie et une deuxième extrémité respectives, et le convertisseur comportant en outre un interrupteur complémentaire connecté directement entre les premières extrémités dudit couple d'ensembles piézoélectriques ;

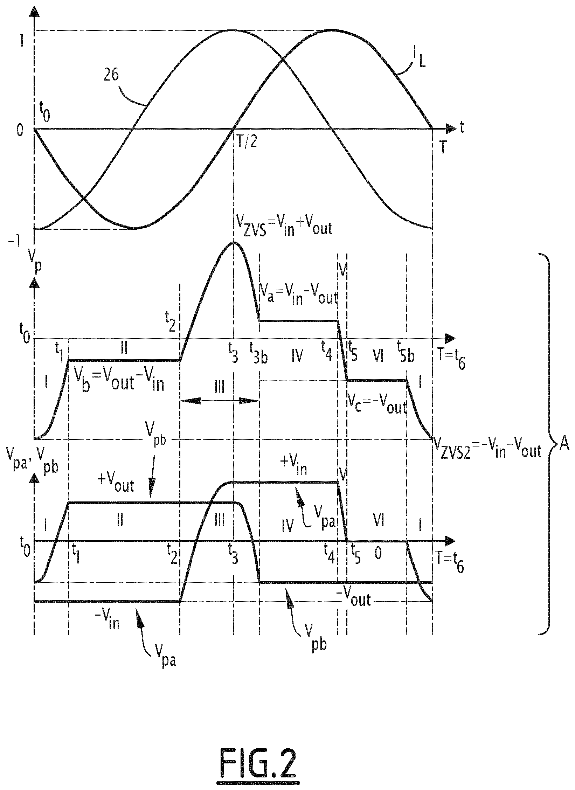

- la figure 2 est un ensemble de courbes représentant un courant circulant dans les ensembles piézoélectriques normalisée à une amplitude de 1, une déformation mécanique totale des ensembles piézoélectriques normalisée à une amplitude de 1, une tension entre des extrémités dudit couple d'ensembles piézoélectriques, une tension entre les autres extrémités dudit couple d'ensembles piézoélectriques, ainsi qu'une tension totale des ensembles piézoélectriques correspondant à la somme desdites tensions élémentaires aux bornes de chaque ensemble piézoélectrique, et ce pour une configuration abaisseur de tension ;
- la figure 3 est une vue analogue à celle de la figure 1, selon un autre exemple du convertisseur d'énergie électrique, où chaque deuxième branche de commutation comporte un seul deuxième interrupteur et l'interrupteur complémentaire est connecté directement entre les deuxièmes extrémités dudit couple d'ensembles piézoélectriques ;
- la figure 4 est une vue analogue à celle de la figure 2 et selon l'exemple de la figure 3, pour une autre configuration de conversion d'énergie électrique, à savoir une configuration très élévateur de tension ;
- la figure 5 est une vue analogue à celle de la figure 1, selon un autre exemple du convertisseur d'énergie électrique, où le convertisseur d'énergie électrique est apte à convertir la tension d'entrée en plusieurs tensions de sortie distinctes, et comporte - pour chaque tension de sortie respective - un couple respectif de premier et deuxième ensembles piézoélectriques et un deuxième pont de commutation respectif, chaque deuxième branche de commutation étant connectée entre deux bornes de fourniture de ladite tension de sortie respective ;
- la figure 6 est une vue analogue à celle de la figure 1, selon un aspect complémentaire où le convertisseur comprend en outre un circuit d'aide à la commutation connecté entre les premières extrémités du couple d'ensembles piézoélectriques ;
- la figure 7 est une représentation schématique de différents types de circuit d'aide à la commutation ;
- la figure 8 est une vue analogue à celle de la figure 2, selon l'aspect complémentaire de la figure 6 ;
- la figure 9 est une vue analogue à celle de la figure 3, selon l'aspect complémentaire avec le circuit d'aide à la commutation connecté entre les deuxièmes extrémités du couple d'ensembles piézoélectriques ; et
- la figure 10 est une vue analogue à celle de la figure 4, selon l'aspect complémentaire de la figure 9.

## DESCRIPTION DETAILLEE

L'expression « sensiblement égal(e) à » définit une relation d'égalité à plus ou moins 10%, de préférence à plus ou moins 5%.

Sur la figure 1, un système électronique de conversion d'énergie électrique 5 comprend un convertisseur d'énergie électrique 10 comportant un couple de premier 12A et deuxième 12B ensembles piézoélectriques, chaque ensemble piézoélectrique 12A,12B comportant au moins un élément piézoélectrique 15, ainsi que plusieurs interrupteurs $K_1, K_2, K_3, K_4, K_5, K_6, K_7, K_8$ aptes à être commandés pour alterner des phases II, IV, VI à tension sensiblement constante aux bornes des ensembles piézoélectriques 12A, 12B et des phases I, III, V à charge sensiblement constante aux bornes des ensembles piézoélectriques 12A, 12B ; et un dispositif électronique 20 de pilotage du convertisseur d'énergie électrique 10.

Le système électronique de conversion d'énergie électrique 5 est typiquement un système de conversion en une énergie électrique continue, tel qu'un système de conversion continu-continu apte à convertir une première énergie ou tension électrique continue reçue en entrée en une deuxième énergie ou tension électrique continue délivrée en sortie, ou encore un système de conversion alternatif-continu apte à convertir une énergie ou tension électrique alternative reçue en entrée en une énergie ou tension électrique continue délivrée en sortie du système de conversion 5.

Lorsque le système de conversion d'énergie électrique 5 est un système de conversion alternatif-continu, le système de conversion d'énergie électrique 5 comprend de préférence en outre un redresseur de tension, non représenté, connecté en entrée du convertisseur d'énergie électrique 10 et apte à redresser la tension électrique alternative reçue en entrée du système de conversion 5 pour délivrer une tension électrique redressée en entrée du convertisseur 10, le convertisseur d'énergie électrique 10 étant de préférence un convertisseur continu-continu apte à convertir une énergie ou tension électrique continue en une autre énergie ou tension électrique continue. Le redresseur de tension est par exemple un pont redresseur, tel qu'un pont de diodes. En variante, le redresseur de tension est formé en partie par des interrupteurs du convertisseur 10.

L'homme du métier observera que ces différents exemples pour le système conversion 5, qu'il s'agisse d'un système de conversion continu-continu ou bien d'un système de conversion alternatif-continu, sont également présentés dans les documents FR 3 086 471 A1 et FR 3 086 472 A1, notamment en regard de leurs figures 1 et 2.

Le convertisseur d'énergie électrique 10 est de préférence un convertisseur continu-continu, et est également appelé convertisseur DC-DC. Le convertisseur continu-continu a généralement pour rôle de réguler une tension d'alimentation d'une charge 22 à une valeur stable, en étant alimenté par une source d'énergie 24 fournissant une tension sensiblement continue. La source d'énergie 24 est par exemple une batterie ou un panneau solaire.

Le convertisseur d'énergie électrique 10 est alors configuré pour élever la valeur de la tension continue entre son entrée et sa sortie, et est alors également appelé convertisseur continu-continu élévateur ; ou bien est configuré pour abaisser la valeur de la tension continue entre son entrée et sa sortie, et est alors appelé convertisseur continu-continu abaisseur.

Le convertisseur d'énergie électrique 10 est configuré pour délivrer N tension(s) de sortie distincte(s), à partir de E tension(s) d'entrée distincte(s), E et N étant chacun un nombre entier supérieur ou égal à 1.

Dans l'exemple de la figure 1, le convertisseur d'énergie électrique 10 est configuré pour délivrer une tension de sortie, notée $V_{out}$, à partir d'une tension d'entrée, notée $V_{in}$, le nombre E de tension(s) d'entrée et le nombre N de tension(s) de sortie étant alors chacun égal à 1.

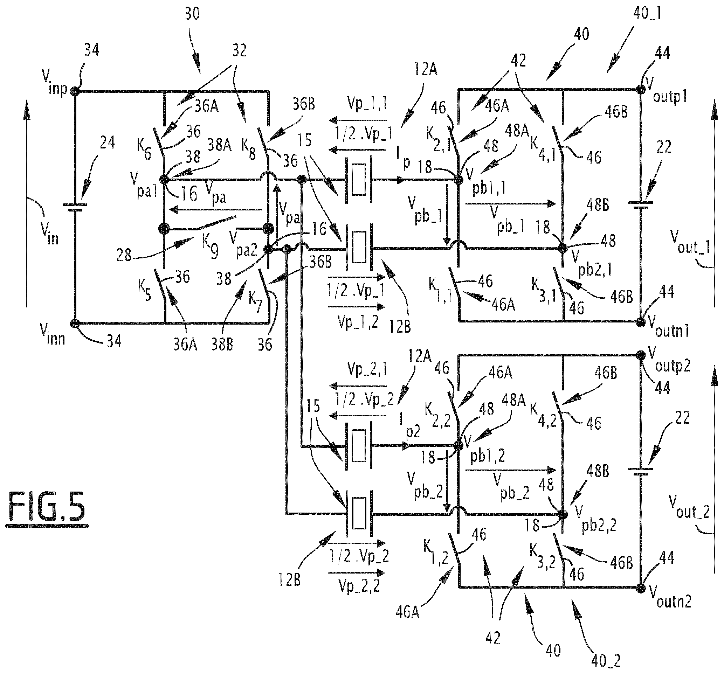

Dans l'exemple de la figure 5, le convertisseur d'énergie électrique 10 est configuré pour délivrer plusieurs tensions de sortie distinctes, notées $V_{out\_j}$ où j est un indice entier compris entre 1 et N, à partir de la tension d'entrée $V_{in}$, le nombre N de tensions de sortie distinctes étant alors supérieur à 1. Selon cet exemple, le convertisseur 10 est typiquement connecté à plusieurs charges 22, comme représenté sur la figure 5.

Le convertisseur d'énergie électrique 10 comporte les ensembles piézoélectriques 12A, 12B formés chacun d'un ou plusieurs éléments piézoélectriques 15, et le dispositif de pilotage 20 est configuré pour faire fonctionner le matériau piézoélectrique des éléments piézoélectriques 15 à leur résonance afin d'exploiter des phases de transfert de charge permettant de s'affranchir de l'utilisation d'un élément inductif, tout en régulant la tension de sortie en conservant la résonance du matériau piézoélectrique, c'est-à-dire avec des cycles de commutation répétés à une fréquence de fonctionnement dépendant de la fréquence de résonance des éléments piézoélectriques 15, et en ajustant les durées entre les commutations respectives à l'intérieur du cycle de résonance.

En régime établi, les ensembles piézoélectriques 12A, 12B échangent une charge et une puissance sensiblement nulle sur un cycle de résonance, aux pertes près. Autrement dit, chaque ensemble piézoélectrique 12A, 12B redonne, sensiblement autant qu'il reçoit, d'énergie et de charge sur une période. Deux conditions de fonctionnement s'appliquent alors au régime permanent/établi, à savoir l'équilibre de charge et l'équilibre d'énergie sur une période de résonance. Même si durant les transitoires (démarrage, variation des paliers de tension, changement du courant de sortie) cette équilibre n'est pas respecté, il faut néanmoins qu'il puisse être atteint en régime établi. Ceci impose notamment un certain agencement des paliers de tension durant la période de résonance. Par exemple, pour un fonctionnement à trois paliers de tension, les deux paliers de tension extrêmes sont commandés lors d'une demi-période d'une polarité donnée d'un courant $I_L$ circulant dans les éléments piézoélectriques 15, et le palier de tension intermédiaire est commandé lors de l'autre demi-période de polarité opposée du courant $I_L$ circulant dans les éléments piézoélectriques 15.

Comme connu en soi, l'oscillation mécanique des éléments piézoélectriques 15 est approximativement sinusoïdale, ainsi que représenté sur les figures 2, 4, 8 et 10 par la courbe 26 illustrant la déformation mécanique totale des éléments piézoélectriques 15 au cours d'un cycle de résonance respectif. La déformation mécanique totale des éléments piézoélectriques 15 est la somme de déformations mécaniques élémentaires de chacun des éléments piézoélectriques 15.

Une augmentation ou une diminution de l'énergie stockée sur une période conduit respectivement à une augmentation ou à une diminution de l'amplitude d'oscillation. Par ailleurs, lors d'une phase à charge sensiblement constante aux bornes des ensembles piézoélectriques 12A, 12B, c'est-à-dire lorsque les éléments piézoélectriques 15 sont placés dans un circuit électrique sensiblement ouvert, avec un faible échange de charges électriques entre les éléments piézoélectriques 15 et l'extérieur, une augmentation de l'amplitude des oscillations engendre une augmentation de la vitesse de variation de la tension $V_p$ aux bornes des ensembles piézoélectriques 12A, 12B, et lors d'une phase II, IV, VI à tension sensiblement constante aux bornes des ensembles piézoélectriques 12A, 12B, cette augmentation d'amplitude d'oscillation conduit à une augmentation du courant $I_L$ circulant dans les éléments piézoélectriques 15.

Par charge sensiblement constante, on entend un échange d'une charge avec l'extérieur qui est inférieur à 10% de la charge qui aurait été échangée avec l'extérieur si la tension avait été maintenue constante. Autrement dit, par charge sensiblement constante, on entend une variation de charge inférieure à 10% de la charge qui aurait été échangée avec l'extérieur des ensembles piézoélectriques 12A, 12B si la tension aux bornes des ensembles piézoélectriques 12A, 12B avait été maintenue constante sur la durée temporelle considérée.

Par circuit électrique sensiblement ouvert, on entend un circuit dont un éventuel courant de fuite conduit à une variation de charge des ensembles piézoélectriques 12A, 12B inférieure à 10% de la charge qui aurait été échangée avec l'extérieur des ensembles piézoélectriques 12A, 12B si la tension aux bornes des ensembles piézoélectriques 12A, 12B avait été maintenue constante sur la durée temporelle considérée.

Par tension sensiblement constante, on entend une variation de tension inférieure à 20%, de préférence inférieure à 10%, de la tension d'entrée ou de sortie du convertisseur 10. À titre d'exemple, si la tension d'entrée du convertisseur 10 est égale à 100V, alors la variation de tension lors de chaque phase II, IV, VI à tension sensiblement constante, c'est-à-dire sur chaque palier à tension sensiblement constante, est inférieure à 20% de cette tension, c'est-à-dire inférieure à 20V ; de préférence inférieure à 10 % de cette tension, c'est-à-dire inférieure à 10V. Chaque phase à tension sensiblement constante est également appelée palier de tension.

Le convertisseur 10 comporte alors plusieurs interrupteurs $K_1$, $K_2$, $K_3$, $K_4$, $K_5$, $K_6$, $K_7$, $K_8$ visibles sur les figures 1, 3, 6 et 9, $K_{1,1}$, $K_{2,1}$, $K_{3,1}$, $K_{4,1}$, $K_{1,2}$, $K_{2,2}$, $K_{3,2}$, $K_{4,2}$, $K_5$, $K_6$, $K_7$, $K_8$ visibles sur la figure 5, aptes à être commandés pour alterner des phases II, IV, VI à tension sensiblement constante et des phases I, III, V à charge sensiblement constante aux bornes des ensembles piézoélectriques 12A, 12B, à l'intérieur de périodes de durée sensiblement constante correspondant à la fréquence de fonctionnement du convertisseur 10, dépendant de la fréquence de résonance, également appelée fréquence propre, des éléments piézoélectriques 15. Les phases I, III, V à charge sensiblement constante permettent, en régime établi ou permanent, de passer d'une tension constante à une autre et de fermer les interrupteurs qui doivent l'être lorsque la tension à leurs bornes est de préférence nulle afin d'avoir une commutation dite à zéro de tension, également appelée commutation en mode ZVS (de l'anglais *Zero Voltage Switching*).

Le convertisseur 10 comprend un premier pont de commutation 30 comportant deux premières branches de commutation 32, chaque première branche de commutation 32 comportant au moins un premier interrupteur 36. Chaque ensemble piézoélectrique 12A,12B comporte une première extrémité 16 connectée au premier pont de commutation 30 ; et chaque premier interrupteur 36 est connecté entre une borne 34 d'application de la tension d'entrée $V_{in}$ et une première extrémité 16 respectives.

Parmi les deux bornes d'application 34 de la tension d'entrée $V_{in}$, l'une présente un potentiel inférieur, noté $V_{inn}$, et l'autre présente un potentiel supérieur, noté $V_{inp}$. Le premier pont de commutation 30 est de préférence constitué des deux premières branches de commutation 32. A chacune des deux bornes d'application 34 de la tension d'entrée $V_{in}$ est connecté au moins un premier interrupteur 36. Autrement dit, au moins un premier interrupteur 36 est connecté à la borne d'application 34 présentant le potentiel inférieur $V_{inn}$, également appelée première borne d'application 34 ; et au moins un autre premier interrupteur 36 est connecté à la borne d'application 34 présentant le potentiel supérieur $V_{inp}$, également appelée deuxième borne d'application 34.

Dans les exemples des figures 1, 3, 5, 6 et 9, chaque première branche de commutation 32 comporte deux premiers interrupteurs 36 connectés en série et reliés entre eux en un premier point milieu 38. Chaque première branche de commutation 32 est de préférence constituée des deux premiers interrupteurs 36.

Lorsque chaque première branche de commutation 32 comporte deux premiers interrupteurs 36 connectés en série et reliés entre eux en un premier point milieu 38 respectif, chaque premier point milieu 38 forme une première extrémité 16 respective.

Dans les exemples des figures 1, 3, 5, 6 et 9, chaque première branche de commutation 32 est connectée entre les deux bornes 34 d'application de la tension d'entrée $V_{in}$.

Dans ces exemples, les deux premiers interrupteurs 36 sont notés $K_5$, $K_6$ pour l'une des deux premières branches de commutation 32, et respectivement $K_7$, $K_8$ pour l'autre des deux premières branches de commutation 32.

Par souci de distinction entre les premiers interrupteurs 36 connectés directement au premier ensemble piézoélectrique 12A et ceux connectés directement au deuxième ensemble piézoélectrique 12B, les premiers interrupteurs 36 connectés directement au premier ensemble piézoélectrique 12A sont également notés 36A, et les premiers interrupteurs 36 connectés directement au deuxième ensemble piézoélectrique 12B sont également notés 36B.

Dans les exemples des figures 1, 3, 5, 6 et 9, les premiers interrupteurs 36A connectés directement au premier ensemble piézoélectrique 12A sont aussi notés $K_5$, $K_6$, et les premiers interrupteurs 36B connectés directement au deuxième ensemble piézoélectrique 12B sont aussi notés $K_7$, $K_8$.

De même, le premier point milieu 38 connecté directement au premier ensemble piézoélectrique 12A est également noté 38A, et le premier point milieu 38 connecté directement au deuxième ensemble piézoélectrique 12B est également noté 38B.

Le convertisseur 10 comprend un deuxième pont de commutation 40 comportant deux deuxièmes branches de commutation 42, chaque deuxième branche de commutation 42 comportant au moins un deuxième interrupteur 46. Chaque ensemble piézoélectrique 12A, 12B comporte une deuxième extrémité 18 connectée au deuxième pont de commutation 40 ; et chaque deuxième interrupteur 46 est connecté entre une borne 44 de fourniture de la tension de sortie $V_{out}$ et une deuxième extrémité 18 respectives.

Parmi les deux bornes de fourniture 44 de la tension de sortie $V_{out}$, l'une présente un potentiel inférieur, noté $V_{outn}$, et l'autre présente un potentiel supérieur, noté $V_{outp}$. Le deuxième pont de commutation 40 est de préférence constitué des deux deuxièmes branches de commutation 42. A chacune des deux bornes de fourniture 44 de la tension de

sortie $V_{out}$ est connecté au moins un deuxième interrupteur 46. Autrement dit, au moins un deuxième interrupteur 46 est connecté à la borne de fourniture 44 présentant le potentiel inférieur $V_{outn}$, également appelée première borne de fourniture 44 ; et au moins un autre deuxième interrupteur 46 est connecté à la borne de fourniture 44 présentant le potentiel supérieur $V_{outp}$, également appelée deuxième borne de fourniture 44.

Dans les exemples des figures 1, 5 et 6, chaque deuxième branche de commutation 42 comporte deux deuxièmes interrupteurs 46 connectés en série et reliés en le deuxième point milieu 48. Chaque deuxième branche de commutation 42 est de préférence constituée des deux deuxièmes interrupteurs 46.

Lorsque chaque deuxième branche de commutation 42 comporte deux deuxièmes interrupteurs 46 connectés en série et reliés entre eux en un deuxième point milieu 48 respectif, chaque deuxième point milieu 48 forme une deuxième extrémité 18 respective.

Dans les exemples des figures 1, 5 et 6, chaque deuxième branche de commutation 42 est connectée entre les deux bornes 44 de fourniture de la tension de sortie $V_{out}$.

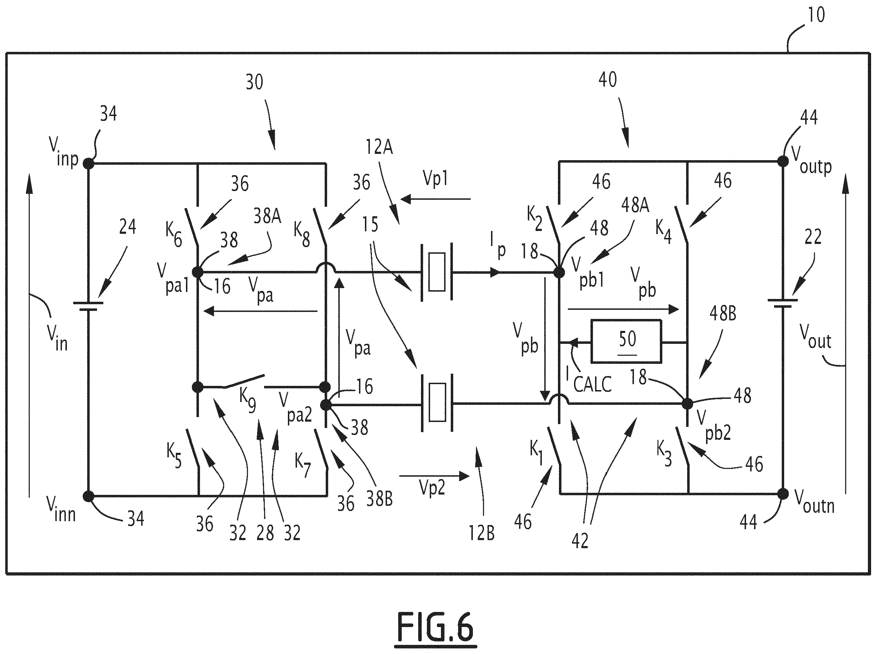

Dans les exemples des figures 1 et 6, les deux deuxièmes interrupteurs 46 sont notés $K_1$, $K_2$ pour l'une des deux deuxièmes branches de commutation 42, et respectivement $K_3$, $K_4$ pour l'autre des deux deuxièmes branches de commutation 42.

Lorsque le convertisseur d'énergie électrique 10 est configuré pour délivrer plusieurs tensions de sortie distinctes $V_{out\_j}$, il comprend, pour chaque tension de sortie $V_{out\_j}$ respective, un deuxième pont de commutation 40 respectif, chaque deuxième branche de commutation 42 étant connectée entre deux bornes 44 de fourniture de la tension de sortie $V_{out\_j}$ respective.

Dans l'exemple de la figure 5, le convertisseur d'énergie électrique 10 est configuré pour délivrer deux tensions de sortie distinctes, à savoir une première tension de sortie $V_{out\_1}$ et une deuxième tension de sortie $V_{out\_2}$. Selon cet exemple, le convertisseur 10 comprend alors deux deuxièmes ponts de commutation 40, celui associé à la première tension de sortie $V_{out\_1}$ étant noté 40_1 et celui associé à la deuxième tension de sortie $V_{out\_2}$ étant noté 40_2. Chaque deuxième branche de commutation 42 étant connectée entre deux bornes 44 de fourniture de la tension de sortie $V_{out\_1}$, $V_{out\_2}$ respective. Dans cet exemple, les potentiels inférieurs des tensions de sortie $V_{out\_1}$, $V_{out\_2}$ sont respectivement notés $V_{outn1}$, $V_{outn2}$, et les potentiels supérieurs des tensions de sortie $V_{out\_1}$, $V_{out\_2}$ sont respectivement notés $V_{outp1}$, $V_{outp2}$. Dans cet exemple encore, les deuxièmes interrupteurs 46 sont notés $K_{1,1}$, $K_{2,1}$, $K_{3,1}$, $K_{4,1}$ pour le deuxième pont de commutation 40_1 associé à la première tension de sortie $V_{out\_1}$, et les deuxièmes interrupteurs 46 sont notés $K_{1,2}$, $K_{2,2}$, $K_{3,2}$, $K_{4,2}$ pour le deuxième pont de commutation 40_2 associé à la deuxième tension de sortie $V_{out\_2}$.

Par souci de distinction entre les deuxièmes interrupteurs 46 connectés directement au premier ensemble piézoélectrique 12A et ceux connectés directement au deuxième ensemble piézoélectrique 12B, les deuxièmes interrupteurs 46 connectés directement au premier ensemble piézoélectrique 12A sont également notés 46A, et les deuxièmes interrupteurs 46 connectés directement au deuxième ensemble piézoélectrique 12B sont également notés 46B.

Dans les exemples des figures 1 et 6, les deuxièmes interrupteurs 46A connectés directement au premier ensemble piézoélectrique 12A sont aussi notés $K_1$, $K_2$, et les deuxièmes interrupteurs 46B connectés directement au deuxième ensemble piézoélectrique 12B sont aussi notés $K_3$, $K_4$.

Dans l'exemple de la figure 5, les deuxièmes interrupteurs 46A connectés directement au premier ensemble piézoélectrique 12A sont aussi notés $K_{1,1}$, $K_{2,1}$, pour le deuxième pont de commutation 40_1 associé à la première tension de sortie $V_{out\_1}$, et $K_{1,2}$, $K_{2,2}$, pour le deuxième pont de commutation 40_2 associé à la deuxième tension de sortie $V_{out\_2}$. Dans cet exemple, les deuxièmes interrupteurs 46B connectés directement au deuxième ensemble piézoélectrique 12B sont aussi notés $K_{3,1}$, $K_{4,1}$ pour le deuxième pont de commutation 40_1 associé à la première tension de sortie $V_{out\_1}$, et $K_{3,2}$, $K_{4,2}$ pour le deuxième pont de commutation 40_2 associé à la deuxième tension de sortie $V_{out\_2}$.

De même, le deuxième point milieu 48 connecté directement au premier ensemble piézoélectrique 12A est également noté 48A, et le deuxième point milieu 48 connecté directement au deuxième ensemble piézoélectrique 12B est également noté 48B.

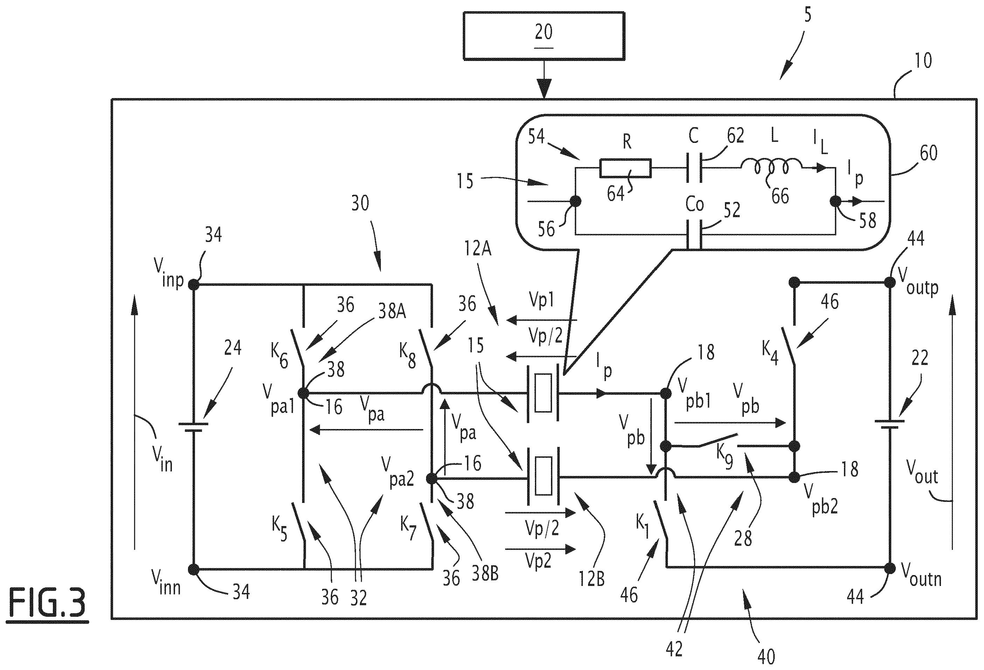

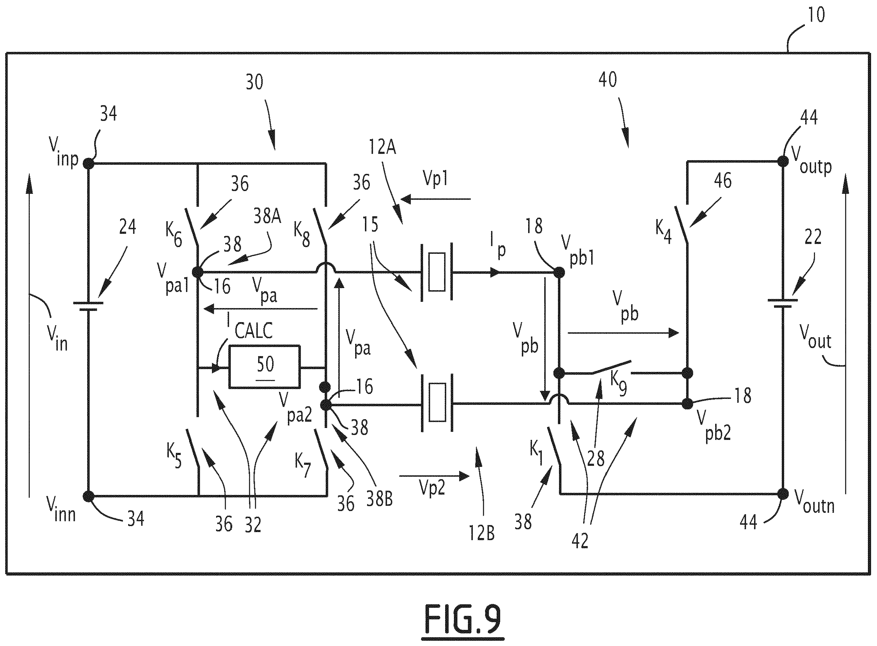

Dans les exemples des figures 3 et 9, chaque deuxième branche de commutation 42 comporte un seul deuxième interrupteur 46 connecté entre une borne 44 de fourniture de la tension de sortie $V_{out}$ et une deuxième extrémité 18 respectives. Chaque deuxième branche de commutation 42 est de préférence constituée d'un unique deuxième interrupteur 46 dans ces exemples des figures 3 et 9.

Dans les exemples des figures 3 et 9, le deuxième interrupteur 46 est noté $K_1$ pour l'une des deux deuxièmes branches de commutation 42, et respectivement $K_4$ pour l'autre des deux deuxièmes branches de commutation 42.

Dans les exemples des figures 3 et 9, le deuxième interrupteur 46A connecté directement au premier ensemble piézoélectrique 12A est aussi noté $K_1$, et le deuxième interrupteur 46B connecté directement au deuxième ensemble piézoélectrique 12B est aussi noté $K_4$.

Le convertisseur 10 comprend un ou plusieurs couples de premier 12A et deuxième 12B ensembles piézoélectriques, chaque ensemble piézoélectrique 12A, 12B comportant au moins un élément piézoélectrique 15 et étant connecté entre des premier 38 et deuxième 48 points milieux respectifs, les points milieux 38, 48 entre lesquels sont connectés les ensembles piézoélectriques 12A,12B étant distincts d'un ensemble piézoélectrique 12A à l'autre 12B.

Dans les exemples des figures 1, 3, 6 et 9, le convertisseur 10 comprend un seul couple de premier 12A et deuxième 12B ensembles piézoélectriques

Lorsque le convertisseur d'énergie électrique 10 est configuré pour délivrer plusieurs tensions de sortie distinctes $V_{out\_j}$, il comprend, pour chaque tension de sortie $V_{out\_j}$ respective, un couple respectif de premier 12A et deuxième 12B ensembles piézoélectriques.

Dans l'exemple de la figure 5, le convertisseur d'énergie électrique 10 est configuré pour délivrer deux tensions de sortie distinctes, et comprend alors deux couples de premier 12A et deuxième 12B ensembles piézoélectriques.

Selon l'invention, le convertisseur 10 comprend en outre au moins un interrupteur complémentaire 28 connecté directement entre les premières extrémités 16, ou respectivement les deuxièmes extrémités 18, d'un couple respectif de premier 12A et deuxième 12B ensembles piézoélectriques, lesdites extrémités 16, 18 reliées directement entre elles via un interrupteur complémentaire 28 respectif étant connectées à un même pont de commutation 30, 40 respectif.

Dans les exemples des figures 1, 5 et 6, le convertisseur 10 comprend un seul interrupteur complémentaire 28 connecté directement entre les premières extrémités 16 d'un couple respectif de premier 12A et deuxième 12B ensembles piézoélectriques.

Dans les exemples des figures 3 et 9, le convertisseur 10 comprend un seul interrupteur complémentaire 28 connecté directement entre les deuxièmes extrémités 18 d'un couple respectif de premier 12A et deuxième 12B ensembles piézoélectriques.

En variante non représentée, le convertisseur 10 comprend deux interrupteurs complémentaires 28, à savoir un premier interrupteur complémentaire 28 connecté directement entre les premières extrémités 16 d'un couple respectif de premier 12A et deuxième 12B ensembles piézoélectriques et un deuxième interrupteur complémentaire 28 connecté directement entre les deuxièmes extrémités 18 d'un couple respectif de premier 12A et deuxième 12B ensembles piézoélectriques.

Ainsi que cela ressort de toutes les figures montrant au moins un interrupteur complémentaire 28, c'est-à-dire des figures 1, 3, 5, 6 et 9, chaque interrupteur complémentaire 28 est connecté uniquement aux extrémités 16, 18 du couple respectif de premier 12A et deuxième 12B ensembles piézoélectriques. Chaque interrupteur complémentaire 28 est distinct des premiers interrupteurs 36 et des deuxièmes interrupteurs 46.

En complément, ainsi que cela ressort également de toutes ces figures montrant au moins un interrupteur complémentaire 28, le convertisseur 10 est dépourvu de connexion directe entre chaque interrupteur complémentaire 28 et une borne 34 respective d'application de la tension d'entrée $V_{in}$ d'une part, et entre chaque interrupteur complémentaire 28 et une borne 44 respective de fourniture de la tension de sortie $V_{out}$ d'autre part. Autrement dit, chaque interrupteur complémentaire 28 n'est pas connecté directement à une borne 34 respective d'application de la tension d'entrée $V_{in}$, et n'est également pas connecté directement à une borne 44 respective de fourniture de la tension de sortie $V_{out}$.

Dans les exemples des figures 1, 3, 5, 6 et 9, chaque interrupteur complémentaire 28 est également noté $K_9$.

Chacun des premiers 36 et deuxièmes 46 interrupteurs est de préférence un interrupteur unidirectionnel en courant et unidirectionnel en tension. L'interrupteur 36, 46 comprend par exemple un transistor, ou une diode, ou encore un transistor et une diode en antiparallèle, non représentés. L'interrupteur 36, 46 est de préférence constitué du transistor, ou de la diode, ou encore du transistor et de la diode en antiparallèle. En variante, l'interrupteur 36, 46 comprend une association de plusieurs transistors, et est de préférence constitué d'une telle association de plusieurs transistors. En variante encore, l'interrupteur 36, 46 comprend un switch mécanique, tel qu'un micro-switch MEMS (de l'anglais *MicroElectroMechanical System).*

Chaque interrupteur complémentaire 28 est de préférence un interrupteur bidirectionnel en tension. Chaque interrupteur complémentaire 28 comprend par exemple deux interrupteurs unidirectionnels, i.e. monodirectionnels, en tension placés tête-bêche en série. Chaque interrupteur unidirectionnel comporte par exemple un transistor, ou une diode, ou encore un transistor et une diode en antiparallèle, non représentés. Chaque interrupteur unidirectionnel est de préférence constitué du transistor, ou de la diode, ou encore du transistor et de la diode en antiparallèle.

L'homme du métier observera que, dans les exemples des figures 3 et 9, chaque interrupteur complémentaire 28 est en variante un interrupteur monodirectionnel en tension.

Le transistor est, par exemple, un transistor à effet de champ à grille isolée, également appelé MOSFET (de l'anglais *Metal Oxide Semiconductor Field Effect Transistor).* En variante, le transistor est un transistor bipolaire ; un transistor bipolaire à grille isolée, également appelé IGBT (de l'anglais *Insulated Gate Bipolar Transistor) ;* un transistor à base de silicium (Si), un transistor à base de GaN (de l'anglais *Gallium Nitride) ;* un transistor à base de carbure de silicium (SiC), ou un transistor à base de diamant, ou encore un thyristor.

Chaque ensemble piézoélectrique 12A, 12B est constitué selon l'une des constitutions parmi le groupe consistant en : un unique élément piézoélectrique 15 ; plusieurs éléments piézoélectriques 15 connectés en série ; plusieurs éléments piézoélectriques 15 connectés en parallèle ; un élément piézoélectrique 15 et un condensateur auxiliaire, non représenté, connectés en série ; un élément piézoélectrique 15 et un condensateur auxiliaire connectés en parallèle ; et un agencement de plusieurs branches parallèles, chaque branche comportant un ou plusieurs éléments piézoélectriques 15 connectés en série ou un condensateur auxiliaire.

Le condensateur auxiliaire est typiquement de capacité supérieure, de préférence au moins trois fois supérieure, à une capacité de référence $C_0$, décrite ci-après, du ou des éléments piézoélectriques 15.

En complément facultatif, les premier 12A et deuxième 12B ensembles piézoélectriques partagent un même matériau piézoélectrique, tout en ayant les électrodes du premier ensemble 12A distinctes de celles du deuxième ensemble 12B. Selon ce complément facultatif, les paires d'électrodes du premier ensemble 12A, et respectivement celles du deuxième ensemble 12B, couvrent des surfaces de matériau distinctes. En outre, les électrodes du premier ensemble 12A ne peuvent dans ce cas pas directement induire un champ électrique significatif dans la partie du matériau piézoélectrique appartenant au second ensemble 12B. Selon ce complément facultatif encore, la capacité entre l'une quelconque des électrodes du premier ensemble 12A et l'une quelconque des électrodes du second ensemble 12B est négligeable (au moins 10 fois inférieure) devant une capacité de référence $C_0$, décrite ci-après, de chacun des ensembles 12A, 12B, par exemple en n'étant pas directement en regard de part et d'autre du matériau. Cette mise en commun d'un même matériau permet par exemple de faciliter l'implémentation des premier 12A et deuxième 12B ensembles piézoélectriques (limitation du nombre de pièce(s), mise en commun des moyens de fixation) ; et aussi de synchroniser la vibration des deux ensembles 12A, 12B, sans toutefois qu'il y ait un transfert significatif d'énergie d'un ensemble à l'autre (<1/10$^{ème}$ de la puissance de sortie).

L'élément piézoélectrique 15 est connu en soi, et est typiquement modélisé, proche du mode de résonnance exploité, sous la forme d'un condensateur 52 et d'une branche résonante 54 connectée en parallèle du condensateur 52, le condensateur 52 et la branche résonante 54 étant connectés entre une première électrode 56 et une deuxième électrode 58 de l'élément piézoélectrique 15, comme illustré sur la modélisation de l'élément piézoélectrique 15 représentée dans une bulle 60 à la figure 1. La branche résonante 54 est typiquement une branche RLC formée d'un condensateur 62, d'une résistance 64 et d'une inductance 66 connectés en série. La capacité du condensateur 52 connecté en parallèle de la branche résonante 54 est appelée capacité parallèle, ou capacité bloquée, ou encore capacité de référence, et notée $C_0$. La tension aux bornes de l'élément piézoélectrique 15 correspond alors typiquement à la tension aux bornes du condensateur 52.

Dans la présente description, une tension dite piézoélectrique totale $V_p$ est par convention la somme de chacune des tensions aux bornes des premier 12A, et respectivement deuxième 12B, ensembles piézoélectriques. En particulier, la tension aux bornes du premier ensemble piézoélectrique 12A est notée $V_{p1}$, et celle aux bornes du deuxième ensemble piézoélectrique 12B est notée $V_{p2}$. La tension piézoélectrique totale $V_p$ est alors égale à la somme de ces tensions $V_{p1}$ et $V_{p2}$, soit $V_{p1}+V_{p2}$. Les deux ensembles piézoélectriques 12A, 12B, et les éléments piézoélectriques 15 les constituant, sont de préférence identiques, et présentent sensiblement la même tension à leurs bornes à une éventuelle tension d'offset $V_{offset}$ près, de sorte que les tensions $V_{p1}$ et $V_{p2}$ sont égales à $V_p/2+/-V_{offset}$, selon les équations suivantes :

[1]

$$V_p = V_{p1} + V_{p2}$$

[2]

$$V_{p1} = \frac{V_p}{2} + V_{offset} \ \text{ et } \ V_{p2} = \frac{V_p}{2} - V_{offset}$$

La tension $V_{offset}$ est une composante sensiblement constante à l'échelle d'une période de résonance et impacte peu l'équilibre de charge ou d'énergie sur une période. Cette tension $V_{offset}$ évolue lentement au regard de la fréquence de pilotage, son ondulation est typiquement à une fréquence au moins 10 fois inférieure à la fréquence de pilotage des ensembles piézoélectriques 12A, 12B. Par ailleurs, lorsque l'on fait la somme des tensions $V_{p1}+V_{p2}$, cette tension d'offset $V_{offset}$ disparait, et on obtient bien la tension piézoélectrique totale $V_p$, telle que décrite dans les différents cycles. En pratique, cette tension d'offset $V_{offset}$ n'impacte pas la loi de pilotage, et autorise des potentiels $V_{in}$ et $V_{outn}$ complètement indépendants en basse fréquence.

Dans l'exemple de la figure 5 où le convertisseur d'énergie électrique 10 est configuré pour délivrer les première $V_{out\_1}$ et deuxième $V_{out\_2}$ tensions de sortie et comprend alors deux couples de premier 12A et deuxième 12B ensembles piézoélectriques, la tension piézoélectrique totale pour un premier couple de premier 12A et deuxième 12B ensembles piézoélectriques associé à la première tension de sortie $V_{out\_1}$ est notée $V_{p\_1}$, et celle pour un deuxième couple de premier 12A et deuxième 12B ensembles piézoélectriques associé à la deuxième tension de sortie $V_{out\_2}$ est notée $V_{p\_2}$. En particulier, la tension aux bornes du premier ensemble piézoélectrique 12A est notée $V_{p\_1,1}$ pour le premier couple et $V_{p\_2,1}$ pour le deuxième couple, et celle aux bornes du deuxième ensemble piézoélectrique 12B est notée $V_{p\_1,2}$ pour le premier couple et $V_{p\_2,2}$ pour le deuxième couple. Chaque tension piézoélectrique totale $V_{p\_1}$, $V_{p\_2}$ est alors égale à la somme de ces tensions respectives $V_{p\_1,1}$, $V_{p\_2,1}$ et $V_{p\_1,2}$, $V_{p\_2,2}$, soit $V_{p\_1,1}$ + $V_{p\_1,2}$, et respectivement $V_{p\_2,1}$ + $V_{p\_2,2}$. Les deux ensembles piézoélectriques 12A, 12B, et les éléments piézoélectriques 15 les constituant, sont de préférence identiques, et présentent sensiblement la même tension à leurs bornes à une éventuelle tension d'offset $V_{offset\_1}$, $V_{offset\_2}$ près, de sorte que les tensions $V_{p\_1,1}$, $V_{p\_2,1}$ et $V_{p\_1,2}$, $V_{p\_2,2}$ sont chacune égales à la moitié de la tension piézoélectrique totale $V_{p\_1}$ +/- $V_{offset\_1}$, $V_{p\_2}$ +/-$V_{offset\_2}$ respective, selon les équations suivantes :

[3]

$$V_{p\_1} = V_{p\_1,1} + V_{p\_1,2}$$

[4]

$$V_{p_{1,1}} = \frac{V_{p_1}}{2} + V_{offset\_1} \quad \text{et} \quad V_{p_{1,2}} = \frac{V_{p_1}}{2} - V_{offset\_1}$$

[5]

$$V_{p\_2} = V_{p\_2,1} + V_{p\_2,2}$$

[6]

$$V_{p_{2,1}} = \frac{V_{p_2}}{2} + V_{offset\_2} \quad \text{et} \quad V_{p_{2,2}} = \frac{V_{p_2}}{2} - V_{offset\_2}$$

En outre, dans la présente description et comme représenté sur les figures 1, 3, 6 et 9, la tension entre les premières extrémités 16 est notée $V_{pa}$, et est par convention égale à la différence de potentiels ($V_{pa1}$ - $V_{pa2}$), où $V_{pa1}$ est le potentiel de la première extrémité 16 connectée au premier ensemble piézoélectrique 12A, et $V_{pa2}$ est le potentiel de l'autre première extrémité 16 connectée au deuxième ensemble piézoélectrique 12B. La tension entre les deuxièmes extrémités 18 est notée $V_{pb}$, et est par convention égale à la différence de potentiels ($V_{pb2}$ - $V_{pb1}$), où $V_{pb1}$ est le potentiel de la deuxième extrémité 18 connectée au premier ensemble piézoélectrique 12A, et $V_{pb2}$ est le potentiel de l'autre deuxième extrémité 18 connectée au deuxième ensemble piézoélectrique 12B.

Par convention et comme représenté sur les figures 1, 3, 6 et 9, la tension $V_{p1}$ aux bornes du premier ensemble piézoélectrique est égale à la différence de potentiels ($V_{pa1}$ - $V_{pb1}$), et celle $V_{p2}$ aux bornes du deuxième ensemble piézoélectrique est égale à la différence de potentiels ($V_{pb2}$ - $V_{pa2}$).

La tension piézoélectrique totale $V_p$ est alors égale à la somme des tensions $V_{pa}$ et $V_{pb}$, et vérifie l'équation suivante :

[7]

$$V_p = V_{pa} + V_{pb}$$

Dans l'exemple de la figure 5 où le convertisseur d'énergie électrique 10 comprend deux couples de premier 12A et deuxième 12B ensembles piézoélectriques et deux deuxièmes ponts de commutation 40_1, 40_2, la tension entre les premières extrémités 16 est aussi notée $V_{pa}$, et est par convention égale à la différence de potentiels ($V_{pa1}$ - $V_{pa2}$), où $V_{pa1}$ est le potentiel de la première extrémité 16 connectée au premier ensemble piézoélectrique 12A, et $V_{pa2}$ est le potentiel de l'autre première extrémité 16 connectée au deuxième ensemble piézoélectrique 12B. La tension entre les deuxièmes extrémités 18 est notée $V_{pb\_1}$ pour le deuxième pont de commutation 40_1 associé à la première tension de sortie $V_{out\_1}$, et est par convention égale à la différence de potentiels ($V_{pb2,1}$ - $V_{pb1,1}$), où $V_{pb1,1}$ est le potentiel de la deuxième extrémité 18 connectée au premier ensemble piézoélectrique 12A, et $V_{pb2,1}$ est le potentiel de l'autre deuxième extrémité 18 connectée au deuxième ensemble piézoélectrique 12B, ceci pour le deuxième pont de commutation 40_1 associé à la première tension de sortie $V_{out\_1}$. De manière analogue, la tension entre les deuxièmes extrémités 18 est notée $V_{pb\_2}$ pour le deuxième pont de commutation 40_2 associé à la deuxième tension de sortie $V_{out\_2}$, et est par convention égale à la différence de potentiels ($V_{pb2,2}$ - $V_{pb1,2}$), où $V_{pb1,2}$ est le potentiel de la deuxième extrémité 18 connectée au premier ensemble piézoélectrique 12A, et $V_{pb2,2}$ est le potentiel de l'autre deuxième extrémité 18 connectée au deuxième ensemble piézoélectrique 12B, ceci pour le deuxième pont de commutation 40_2 associé à la deuxième tension de sortie

$V_{out\_2}$.

Par convention et comme représenté sur la figure 5, la tension aux bornes du premier ensemble piézoélectrique $V_{p\_1,1}$ du premier couple est égale à la différence de potentiels $(V_{pa1} - V_{pb1,1})$, et celle aux bornes du deuxième ensemble piézoélectrique $V_{p\_1,2}$ du premier couple est égale à la différence de potentiels $(V_{pb2,1} - V_{pa2})$. De même, la tension aux bornes du premier ensemble piézoélectrique $V_{p\_2,1}$ du deuxième couple est égale à la différence de potentiels $(V_{pa1} - V_{pb1,2})$, et celle aux bornes du deuxième ensemble piézoélectrique $V_{p\_2,2}$ du deuxième couple est égale à la différence de potentiels $(V_{pb2,2} - V_{pa2})$.

La fréquence de résonance est la fréquence à laquelle oscille l'élément piézoélectrique 15 et par conséquent son courant $I_L$, visible sur la figure 1. Le cycle de conversion est synchronisé sur un mouvement mécanique de l'élément piézoélectrique 15, et la fréquence du pilotage est alors calée sur la fréquence d'oscillation mécanique. En pratique, cette fréquence d'oscillation dépend du point de fonctionnement du convertisseur 10 : valeurs des trois paliers de tension et du courant de sortie. En fonction du point de fonctionnement, cette fréquence d'oscillation évolue typiquement entre la fréquence de résonance dite série de l'élément piézoélectrique 15 ($\omega_s = 1/\sqrt{L_r.C_r}$ où $L_r$ et $C_r$ correspondent aux inductance et capacité de la branche résonante 54) et la fréquence de résonance dite parallèle de l'élément piézoélectrique 15 ($\omega_p = 1/\sqrt{L_r.C_r.C_0/(C_r+C_0)}$), également respectivement appelés fréquence de résonance et fréquence d'antirésonance de l'élément piézoélectrique 15. La fréquence de fonctionnement du convertisseur 10 est alors comprise entre ces deux fréquences de résonance et d'antirésonance de l'élément piézoélectrique 15. Le point de fonctionnement varie lentement au regard de la fréquence d'oscillation de l'élément piézoélectrique 15. Le point de fonctionnement évolue typiquement à moins de 10kHz, alors que la fréquence d'oscillation de l'élément piézoélectrique 15 est typiquement supérieure ou égale à 100kHz. De ce fait, la fréquence de fonctionnement du convertisseur 10 évolue peu d'une période à la suivante.

D'une manière générale, pour le convertisseur d'énergie électrique 10 avec les ensembles piézoélectriques 12A, 12B et piloté par le dispositif électronique de pilotage 20, le nombre de phases II, IV, VI à tension sensiblement constante est typiquement d'au moins 2, de préférence égal à 3, tout en pouvant être supérieur ou égal à 4 avec la mise en œuvre du pilotage décrit dans la demande FR 21 07345 déposée le 7 juillet 2021.

Chaque phase II, IV, VI à tension sensiblement constante est susceptible d'être obtenue à partir d'une combinaison des tensions d'entrée et de sortie, en valeur positive ou négative. Le convertisseur d'énergie 10 permet alors d'échanger de l'énergie durant les phases II, IV, VI à tension sensiblement constante, et par voie de conséquence, avec les combinaisons de tensions utilisées pour obtenir ces phases II, IV, VI à tension sensiblement constante. Il est notamment possible de transférer de l'énergie d'une phase à tension sensiblement constante de faible tension vers une phase à tension sensiblement constante de tension plus élevée, et par le jeu des combinaisons précitées obtenir au final un convertisseur abaisseur de tension, ce qui peut paraître contre-intuitif. Inversement, il est également possible de transférer de l'énergie d'une phase à tension sensiblement constante de tension élevée vers une phase à tension sensiblement constante de tension plus faible, et par le jeu des combinaisons précitées obtenir au final un convertisseur élévateur de tension. L'homme du métier comprendra alors qu'il est possible d'avoir un cycle élévateur vu par les ensembles piézoélectriques 12A, 12B alors que le convertisseur d'énergie électrique 10 est un convertisseur abaisseur, et inversement d'avoir un cycle abaisseur vu par les ensembles piézoélectriques 12A, 12B alors que le convertisseur d'énergie électrique 10 est un convertisseur élévateur.

Par convention, si un courant est fourni aux ensembles piézoélectriques 12A, 12B lors de la phase II, IV, VI à tension sensiblement constante correspondant à la tension la plus élevée au cours d'un cycle de résonance, alors le cycle est considéré comme un cycle abaisseur pour les ensembles piézoélectriques 12A, 12B. Inversement, si un courant est débité, ou encore tiré, depuis les ensembles piézoélectriques 12A, 12B lors de ladite phase II, IV, VI à tension sensiblement constante pour laquelle la tension est la plus élevée au cours du cycle de résonance, alors le cycle est considéré comme un cycle élévateur pour les ensembles piézoélectriques 12A, 12B. Comme indiqué précédemment, le cycle de conversion vu par les ensembles piézoélectriques 12A, 12B est susceptible d'être un cycle élévateur alors que le convertisseur d'énergie électrique 10 fonctionne en convertisseur abaisseur, et inversement le cycle de conversion vu par les ensembles piézoélectriques 12A, 12B est susceptible d'être un cycle abaisseur alors que le convertisseur d'énergie électrique 10 fonctionne en convertisseur élévateur.

Le dispositif électronique de pilotage 20 est configuré pour piloter le convertisseur d'énergie électrique 10, en particulier pour piloter la commande des interrupteurs 36, 46 du convertisseur, afin d'alterner, lors d'un cycle respectif de résonance des ensembles piézoélectriques 12A,12B, des phases II, IV, VI à tension sensiblement constante aux bornes des ensembles piézoélectriques 12A, 12B et des phases I, III, V à charge sensiblement constante, c'est-à-dire en circuit sensiblement ouvert, aux bornes desdits ensembles piézoélectriques 12A, 12B.

Le dispositif électronique de pilotage 20 est par exemple réalisé sous forme d'un circuit électronique comportant un ou plusieurs composants électroniques.

En variante, le dispositif électronique de pilotage 20 est réalisé sous forme d'un composant logique programmable, tel qu'un FPGA (de l'anglais *Field Programmable Gate Array),* ou sous forme d'un circuit intégré, tel qu'un ASIC (de l'anglais *Application Specific Integrated Circuit*) ou encore sous forme d'un calculateur, tel qu'un microcontrôleur, un processeur.

Le dispositif électronique de pilotage 20 est configuré en outre pour, lors d'au moins une phase II, IV, VI à tension sensiblement constante, commander au moins un interrupteur complémentaire 28 respectif en position fermée.

L'homme du métier comprendra alors que lorsque le convertisseur 10 comprend un interrupteur complémentaire 28 respectif connecté directement entre les premières extrémités 16 d'un couple respectif de premier 12A et deuxième 12B ensembles piézoélectriques, alors la commande en position fermée dudit interrupteur complémentaire 28 permet de forcer à la valeur nulle la tension $V_{pa}$ entre les premières extrémités 16.

De manière analogue, lorsque le convertisseur 10 comprend un interrupteur complémentaire 28 respectif connecté directement entre les deuxièmes extrémités 18 d'un couple respectif de premier 12A et deuxième 12B ensembles piézoélectriques, alors la commande en position fermée dudit interrupteur complémentaire 28 permet de forcer à la valeur nulle la tension $V_{pb}$ entre les deuxièmes extrémités 18.

De manière analogue encore, lorsque le convertisseur 10 comprend deux interrupteurs complémentaires 28 connectés à un même couple de premier 12A et deuxième 12B ensembles piézoélectriques, c'est-à-dire à la fois le premier interrupteur complémentaire 28 connecté directement entre les premières extrémités 16 dudit couple et un deuxième interrupteur complémentaire 28 connecté directement entre les deuxièmes extrémités 18 dudit couple, alors la commande en position fermée de ces premier et deuxième interrupteurs complémentaires 28 permet de forcer à la fois la tension $V_{pa}$ entre les premières extrémités 16 à la valeur nulle et la tension $V_{pb}$ entre les deuxièmes extrémités 18 à la valeur nulle, et donc de forcer la tension piézoélectrique totale $V_p$ dudit couple d'ensembles piézoélectriques à la valeur nulle.

En complément, le dispositif électronique de pilotage 20 est configuré pour, lors de chaque phase I, III, V à charge sensiblement constante, commander en position fermée en même temps au plus un interrupteur respectif parmi les interrupteurs 36A, 46A connectés directement au premier ensemble piézoélectrique 12A et au plus un interrupteur respectif parmi les interrupteurs 36B, 46B connectés directement au deuxième ensemble piézoélectrique 12B, et en position ouverte tous les autres interrupteurs 36, 46 des premières et deuxièmes branches de commutation 32, 42.

Selon ce complément, autrement dit, lors de chaque phase I, III, V à charge sensiblement constante, au plus un interrupteur respectif parmi les interrupteurs 36A, 46A connectés directement au premier ensemble piézoélectrique 12A et au plus un interrupteur respectif parmi les interrupteurs 36B, 46B connectés directement au deuxième ensemble piézoélectrique 12B sont en position fermée en même temps, tous les autres interrupteurs 36, 46 des premières et deuxièmes branches de commutation 32, 42 étant en position ouverte.

Selon ce complément, en d'autres termes, lors de chaque phase I, III, V à charge sensiblement constante, à chaque instant au plus un interrupteur respectif parmi les interrupteurs 36A, 46A connectés directement au premier ensemble piézoélectrique 12A est en position fermée, et au plus un interrupteur respectif parmi les interrupteurs 36B, 46B connectés directement au deuxième ensemble piézoélectrique 12B est en position fermée, et tous les autres interrupteurs 36, 46 des premières et deuxièmes branches de commutation 32, 42 sont en position ouverte.

Selon ce complément, dans les exemples des figures 1 et 6, lors de chaque phase I, III, V à charge sensiblement constante, au plus un interrupteur respectif parmi les interrupteurs $K_1$, $K_2$, $K_5$, $K_6$ est en position fermée, et au plus un interrupteur respectif parmi les interrupteurs $K_3$, $K_4$, $K_7$, $K_8$ est en position fermée, tous les autres interrupteurs des premières et deuxièmes branches de commutation 32, 42 étant en position ouverte.

Selon ce complément, dans l'exemple de la figure 5 où le convertisseur d'énergie électrique 10 est configuré pour délivrer les première $V_{out\_1}$ et deuxième $V_{out\_2}$ tensions de sortie distinctes respectives, et comprend alors deux couples de premier 12A et deuxième 12B ensembles piézoélectriques et deux deuxièmes ponts de commutation 40_1, 40_2, d'une part pour la conversion de la tension d'entrée $V_{in}$ en la première tension de sortie $V_{out\_1}$ via le premier pont de commutation 30 et le deuxième pont de commutation 40_1 associé à la première tension de sortie $V_{out\_1}$, lors de chaque phase I, III, V à charge sensiblement constante, au plus un interrupteur respectif parmi les interrupteurs $K_{1,1}$, $K_{2,1}$, $K_5$, $K_6$ est en position fermée, et au plus un interrupteur respectif parmi les interrupteurs $K_{3,1}$, $K_{4,1}$, $K_7$, $K_8$ est en position fermée, tous les autres interrupteurs des ponts de commutation 30, 40_1 étant en position ouverte. D'autre part pour la conversion de la tension d'entrée $V_{in}$ en la deuxième tension de sortie $V_{out\_2}$ via le premier pont de commutation 30 et le deuxième pont de commutation 40_2 associé à la deuxième tension de sortie $V_{out\_2}$, lors de chaque phase I, III, V à charge sensiblement constante, au plus un interrupteur respectif parmi les interrupteurs $K_{1,2}$, $K_{2,2}$, $K_5$, $K_6$ est en position fermée, et au plus un interrupteur respectif parmi les interrupteurs $K_{3,2}$, $K_{4,2}$, $K_7$, $K_8$ est en position fermée, tous les autres interrupteurs des ponts de commutation 30, 40_2 étant en position ouverte.

Selon ce complément, le dispositif électronique de pilotage 20 est de préférence configuré pour, lors des phases II, IV, VI à tension sensiblement constante aux bornes des ensembles piézoélectriques 12A, 12B et en l'absence de commande d'un interrupteur complémentaire 28 respectif en position fermée lors de ces phases, piloter la commande des interrupteurs 36, 46 du convertisseur 10, afin d'avoir la valeur $V_a$, $V_b$, $V_c$ de la tension de chacune des phases II, IV, VI à tension sensiblement constante choisie parmi le groupe de valeurs consistant en : différence $V_{in} - V_{out}$ entre la valeur de la tension d'entrée $V_{in}$ et celle de la tension de sortie $V_{out}$ ; différence $V_{out} - V_{in}$ entre la valeur de la tension de sortie $V_{out}$ et celle de la tension d'entrée $V_{in}$ ; somme $V_{in} + V_{out}$ des valeurs des tensions d'entrée $V_{in}$ et de sortie $V_{out}$ ; et opposé de la somme $-V_{in} - V_{out}$ des valeurs des tensions d'entrée $V_{in}$ et de sortie $V_{out}$.

Avec la commande d'au moins un interrupteur complémentaire 28 respectif en position fermée lors d'une phase II, IV, VI respective à tension sensiblement constante, ledit groupe de valeurs comporte en outre les valeurs additionnelles possibles suivantes : valeur de la tension d'entrée $V_{in}$ ; opposé -$V_{in}$ de la valeur de la tension d'entrée $V_{in}$ ; valeur de la tension de sortie $V_{out}$ ; opposé -$V_{out}$ de la valeur de la tension de sortie $V_{out}$ ; et valeur nulle.

Ledit groupe de valeurs comporte la valeur de la tension d'entrée $V_{in}$ et l'opposé -$V_{in}$ de la valeur de la tension d'entrée, si le convertisseur 10 comprend un interrupteur complémentaire 28 respectif connecté directement entre les deuxièmes extrémités 18 d'un couple respectif de premier 12A et deuxième 12B ensembles piézoélectriques, lesdites deuxièmes extrémités 18 étant connectées au deuxième pont de commutation 40. Dans ce cas, la commande en position fermée dudit interrupteur complémentaire 28 permet de forcer à la valeur nulle la tension $V_{pb}$ entre les deuxièmes extrémités 18, et la tension $V_{pa}$ entre les premières extrémités 16 est égale à la tension d'entrée $V_{in}$ ou bien à l'opposé -$V_{in}$ de la tension d'entrée $V_{in}$, de sorte que ledit groupe de valeurs pour la tension piézoélectrique totale $V_p$ comporte alors en outre la valeur de la tension d'entrée $V_{in}$ et l'opposé -$V_{in}$ de la valeur de la tension d'entrée.

Ledit groupe de valeurs comporte la valeur de la tension de sortie $V_{out}$ et l'opposé -$V_{out}$ de la valeur de la tension de sortie, si le convertisseur 10 comprend un interrupteur complémentaire 28 respectif connecté directement entre les premières extrémités 16 d'un couple respectif de premier 12A et deuxième 12B ensembles piézoélectriques, lesdites premières extrémités 16 étant connectées au premier pont de commutation 30. En effet, dans ce cas, la commande en position fermée dudit interrupteur complémentaire 28 permet de forcer à la valeur nulle la tension $V_{pa}$ entre les premières extrémités 16, et la tension $V_{pb}$ entre les deuxièmes extrémités 18 est égale à la tension de sortie $V_{out}$ ou à l'opposé -$V_{out}$ de la tension de sortie, de sorte que ledit groupe de valeurs pour la tension piézoélectrique totale $V_p$ comporte alors en outre la valeur de la tension de sortie $V_{out}$ et l'opposé -$V_{out}$ de la valeur de la tension de sortie.

Ledit groupe de valeurs comporte la valeur nulle, si le convertisseur 10 comprend deux interrupteurs complémentaires 28 connectés à un même couple de premier 12A et deuxième 12B ensembles piézoélectriques, comme décrit précédemment. Dans ce cas, la commande en position fermée de ces premier et deuxième interrupteurs complémentaires 28 permet de forcer à la valeur nulle à la fois la tension $V_{pa}$ entre les premières extrémités 16 et la tension $V_{pb}$ entre les deuxièmes extrémités 18, et donc de forcer la tension piézoélectrique totale $V_p$ dudit couple d'ensembles piézoélectriques à la valeur nulle.

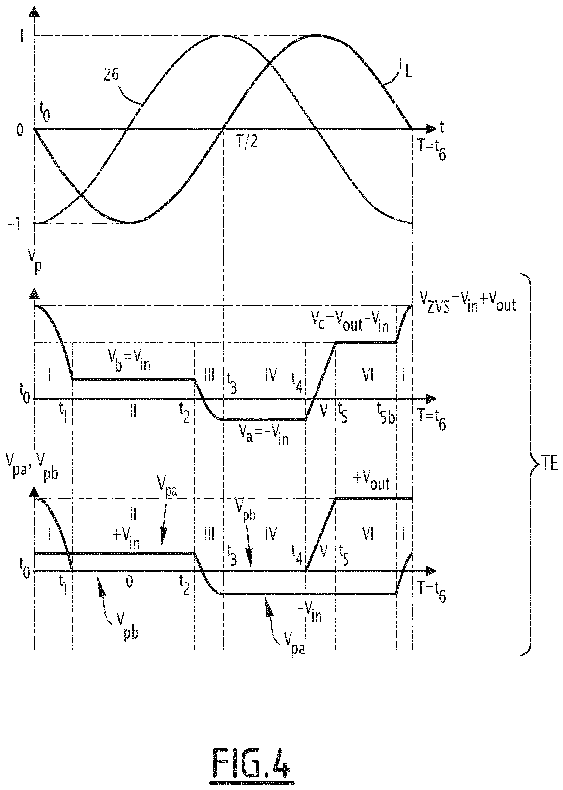

Le fonctionnement du convertisseur 10 va désormais être expliqué, à titre d'exemple, selon une configuration abaisseur de tension A en regard de la figure 2 pour le convertisseur 10 de la figure 1 ; puis selon une configuration très élévateur de tension TE en regard de la figure 4 pour le convertisseur 10 de la figure 3.

Le procédé de pilotage du convertisseur d'énergie électrique 10 est alors mis en œuvre par le dispositif électronique de pilotage 20 et comprend la commande, lors d'un cycle respectif de résonance des ensembles piézoélectriques 12A,12B, d'une commutation de chacun des interrupteurs 36, 46 pour alterner des phases II, IV, VI à tension sensiblement constante aux bornes des ensembles piézoélectriques 12A,12B et des phases I, III, V à charge sensiblement constante aux bornes desdits ensembles piézoélectriques 12A,12B.

Selon l'invention, lors d'au moins une phase II, IV, VI à tension sensiblement constante, au moins un interrupteur complémentaire 28 respectif est commandé en position fermée.

En complément, pour chacune des configurations abaisseur ou très abaisseur, respectivement élévateur ou très élévateur, lors de chaque phase I, III, V à charge sensiblement constante, au plus un interrupteur respectif parmi les interrupteurs 36A, 46A connectés directement au premier ensemble piézoélectrique 12A et au plus un interrupteur respectif parmi les interrupteurs 36B, 46B connectés directement au deuxième ensemble piézoélectrique 12B sont commandés en position fermée en même temps, et tous les autres interrupteurs 36, 46 des premières et deuxièmes branches de commutation 32, 42 sont commandés en position ouverte.

L'homme du métier notera que par configuration très élévateur, on entend typiquement une configuration où le gain, c'est-à-dire le ratio de la tension de sortie $V_{out}$ divisée par la tension d'entrée $V_{in}$, est supérieur à 2, i.e. $V_{out}/V_{in} > 2$. Corollairement, par configuration très abaisseur, on entend typiquement une configuration où le gain, c'est-à-dire le ratio de la tension de sortie $V_{out}$ par la tension d'entrée $V_{in}$, est inférieur à 1/2, i.e. $V_{out}/V_{in} < 1/2$.

De même, par configuration élévateur, on entend typiquement une configuration où ledit gain est compris entre 1 et 2, i.e. $V_{in} < V_{out} < 2V_{in}$. Corollairement, par configuration abaisseur, on entend typiquement une configuration où ledit gain est compris entre 1/2 et 1, i.e. $V_{in}/2 < V_{out} < V_{in}$.

Les principaux exemples de configurations abaisseur, à savoir première configuration abaisseur A1 et deuxième configuration abaisseur A2 ; configurations très abaisseur, à savoir première configuration très abaisseur TA1 et deuxième configuration très abaisseur TA2 ; configurations élévateur, à savoir première configuration élévateur E1 et deuxième configuration élévateur E2 ; et configurations très élévateur, à savoir première configuration très élévateur TE1 et deuxième configuration très élévateur TE2 ; sont alors listés dans le tableau 1 ci-après, avec indications respectives de la valeur $V_b$ de la tension piézoélectrique totale $V_p$ lors de la phase II à tension sensiblement constante, de la valeur $V_a$, de la tension piézoélectrique totale $V_p$ lors de la phase IV à tension sensiblement constante et de la valeur $V_c$ de la tension piézoélectrique totale $V_p$ lors de la phase VI à tension sensiblement constante.

L'homme du métier observera que pour chaque mode de conversion, à savoir abaisseur, très abaisseur, élévateur et très élévateur, les première et deuxième configurations respectives sont à chaque fois similaires dans cet exemple, avec simplement une inversion des polarités entre les première et deuxième configurations respectives.

[Table 1]

| Mode | Configuration | Phase II | Phase IV | Phase VI |
|---|---|---|---|---|
| Abaisseur $V_{in}/2 < V_{out} < V_{in}$ (i.e. $V_{out} > V_{in}-V_{out}$) | A1 | $V_b = V_{in} - V_{out}$ | $V_a = V_{out} - V_{in}$ | $V_c = V_{out}$ |
| | A2 A (Fig. 2), A_C (Fig. 8) | $V_b = V_{out} - V_{in}$ | $V_a = V_{in} - V_{out}$ | $V_c = -V_{out}$ |
| Très abaisseur $V_{out} < V_{in}/2$ (i.e. $V_{out} < V_{in}-V_{out}$) | TA1 | $V_b = V_{out}$ | $V_a = V_{in} - V_{out}$ | $V_c = -V_{out}$ |
| | TA2 | $V_b = -V_{out}$ | $V_a = V_{out} - V_{in}$ | $V_c = V_{out}$ |
| Elévateur $V_{out}/2 < V_{in} < V_{out}$ (i.e. $V_{in} > V_{out}-V_{in}$) | E1 | $V_b = V_{out} - V_{in}$ | $V_a = V_{in}$ | $V_c = V_{in} - V_{out}$ |
| | E2 | $V_b = V_{in} - V_{out}$ | $V_a = -V_{in}$ | $V_c = V_{out} - V_{in}$ |
| Très élévateur $V_{in} < V_{out}/2$ (i.e. $V_{in} < V_{out}-V_{in}$) | TE1 TE (Fig. 4), TE_C (Fig. 10) | $V_b = V_{in}$ | $V_a = -V_{in}$ | $V_c = V_{out} - V_{in}$ |
| | TE2 | $V_b = -V_{in}$ | $V_a = V_{in}$ | $V_c = V_{in} - V_{out}$ |

### Configuration abaisseur A (avec $V_{in}/2 < V_{out} < V_{in}$) (exemple A2)

Sur la figure 2, de l'instant temporel $t_{5b}$ précédent à l'instant temporel $t_1$, correspondant à une première phase I, la tension piézoélectrique totale $V_p$ passe de $-V_{out}$ à $-V_{in}+V_{out}$, avec une excursion à la tension $V_{ZVS2}$ égale à $-V_{in}-V_{out}$ en l'instant temporel $t_0$ (ou l'instant temporel $t_6$) compris entre les instants temporels $t_{5b}$ et $t_1$. Cette excursion de tension permet de passer du palier de tension piézoélectrique totale $V_p$ égal à $-V_{out}$ au palier de tension piézoélectrique totale $V_p$ égal à $V_{out}-V_{in}$ en commutation ZVS au niveau des interrupteurs.

Ce passage se fait en deux étapes, une première étape de l'instant temporel $t_{5b}$ précédent à l'instant temporel $t_0$ (ou l'instant temporel $t_6$) pour passer de la tension piézoélectrique totale $V_p$ égale à $-V_{out}$ à la tension piézoélectrique totale $V_p$ égale à $-V_{in}-V_{out}$, puis une seconde étape de l'instant temporel $t_0$ à l'instant temporel $t_1$ pour passer de la tension piézoélectrique totale $V_p$ égale à $-V_{in}-V_{out}$ à la tension piézoélectrique totale $V_p$ égale à $-V_{in}+V_{out}$.

Lors de cette première phase I, le signe du courant $I_L$ circulant dans les éléments piézoélectriques 15 conduit à une diminution de de la tension piézoélectrique totale $V_p$ durant la première étape jusqu'à l'instant temporel $t_0$, puis à une augmentation de la tension piézoélectrique totale $V_p$ durant la deuxième étape de l'instant temporel $t_0$ à l'instant temporel $t_1$.

Durant la première étape, seule la tension $V_{pa}$ a besoin d'être modifiée, et doit passer de 0 à $-V_{in}$, la tension piézoélectrique totale $V_p$ passant de $-V_{out}$ à $-V_{in}-V_{out}$, ce qu'elle fait naturellement avec la diminution de la tension piézoélectrique totale $V_p$, l'interrupteur complémentaire $K_9$ ayant été ouvert en l'instant temporel $t_{5b}$, comme expliqué ci-après, tandis que la tension $V_{pb}$ reste constante et fixée à $-V_{out}$ via le maintien des interrupteurs $K_2$ et $K_3$ passants (soit en maintenant une commande de fermeture, soit naturellement via leur diode inverse intrinsèque, soit encore via une diode parallèle additionnelle).

Durant la première étape de la première phase I, à charge sensiblement constante, seuls les interrupteurs $K_2$ et $K_3$ sont alors passants ou commandés en position fermée.

En l'instant temporel $t_0$, la tension $V_{pa}$ et la tension $V_{pb}$ sont donc pré-positionnées sur respectivement $-V_{in}$ et $-V_{out}$, et la fermeture des interrupteurs $K_5$, $K_8$ s'effectue en mode ZVS. Les interrupteurs $K_5$ et $K_8$ se ferment, tandis que les interrupteurs $K_2$ et $K_3$ s'ouvrent.

De l'instant temporel $t_0$ à l'instant temporel $t_1$, le signe du courant $I_L$ conduit à une augmentation de la tension piézoélectrique totale $V_p$. La tension piézoélectrique totale $V_p$ passe donc de $-V_{in}-V_{out}$ à $-V_{in}+V_{out}$. Seule la tension $V_{pb}$ a besoin d'être modifiée, et doit passer de $-V_{out}$ à $+V_{out}$, ce qu'elle fait naturellement avec l'augmentation de la tension piézoélectrique totale $V_p$, tandis que la tension $V_{pa}$ reste constante et fixée à $-V_{in}$ via le maintien des interrupteurs $K_5$ et $K_8$ fermés.

Durant la deuxième étape de la première phase I, à charge sensiblement constante, seuls les interrupteurs $K_5$ et $K_8$ sont alors commandés en position fermée.

En l'instant temporel $t_1$, les tensions $V_{pa}$ et $V_{pb}$ sont donc déjà repositionnées sur les valeurs du palier de tension suivant, et la fermeture des interrupteurs $K_1$, $K_4$ s'effectue en mode ZVS, c'est-à-dire avec une tension sensiblement nulle à leurs bornes avant leur fermeture. Si les interrupteurs $K_1$ et $K_4$ disposent d'une diode inverse intrinsèque ou d'une diode additionnelle placée en parallèle, leur mise en conduction peut se faire naturellement au regard du signe du courant. Les interrupteurs $K_5$, $K_8$ étaient déjà fermés.

De l'instant temporel $t_1$ à l'instant temporel $t_2$, correspondant à une deuxième phase II, les interrupteurs $K_1$, $K_4$, $K_5$ et $K_8$ sont passants ou commandés en position fermée. La tension piézoélectrique totale $V_p$ est égale à $-V_{in}+V_{out}$. Une puissance positive est tirée sur la tension d'entrée $V_{in}$ en même temps qu'une puissance positive est fournie à la tension de sortie $V_{out}$.

De l'instant temporel $t_2$ à l'instant temporel $t_{3b}$, correspondant à une troisième phase III, le signe du courant $I_L$ conduit à une augmentation de la tension piézoélectrique totale $V_p$ de l'instant temporel $t_2$ à l'instant temporel $t_3$, puis à une diminution de la tension piézoélectrique totale $V_p$ de l'instant temporel $t_3$ à l'instant temporel $t_{3b}$. La tension piézoélectrique totale $V_p$ passe de $-V_{in}+V_{out}$ à $+V_{in}-V_{out}$, avec une excursion à la tension $V_{ZVS}$ égale à $+V_{in}+V_{out}$ en l'instant temporel $t_3$ compris entre les instants temporels $t_2$ et $t_{3b}$. Cette excursion de tension permet de passer du palier de tension piézoélectrique totale $V_p$ égal à $-V_{in}+V_{out}$ au palier de tension piézoélectrique totale $V_p$ égal à $V_{in}-V_{out}$ en commutation ZVS au niveau des interrupteurs.

Ce passage se fait en deux étapes, une première étape de l'instant temporel $t_2$ à l'instant temporel $t_3$ pour passer de la tension piézoélectrique totale $V_p$ égale à $-V_{in}+V_{out}$ à la tension piézoélectrique totale $V_p$ égale à $V_{in}+V_{out}$, puis une seconde étape de l'instant temporel $t_3$ à l'instant temporel $t_{3b}$ pour passer de la tension piézoélectrique totale $V_p$ égale à $V_{in}+V_{out}$ à la tension piézoélectrique totale $V_p$ égale à $V_{in}-V_{out}$.

De l'instant temporel $t_2$ à l'instant temporel $t_3$, correspondant à la première étape de la troisième phase III, le signe du courant $I_L$ conduit à une augmentation de la tension piézoélectrique totale $V_p$. La tension piézoélectrique totale $V_p$ passe donc de $-V_{in}+V_{out}$ à $V_{in}+V_{out}$. Seule la tension $V_{pa}$ a besoin d'être modifiée, et doit passer de $-V_{in}$ à $+V_{in}$, ce qu'elle fait naturellement avec l'augmentation de la tension piézoélectrique totale $V_p$, tandis que la tension $V_{pb}$ reste constante et fixée à $+V_{out}$ via le maintien des interrupteurs $K_1$ et $K_4$ passants (soit en maintenant une commande de fermeture, soit naturellement via leur diode inverse intrinsèque, soit encore via une diode parallèle additionnelle).

Durant la première étape de la troisième phase III, à charge sensiblement constante, seuls les interrupteurs $K_1$ et $K_4$ sont alors commandés en position fermée.

En l'instant temporel $t_3$, la tension $V_{pa}$ et la tension $V_{pb}$ sont donc pré-positionnées sur respectivement $+V_{in}$ et $+V_{out}$, et la fermeture des interrupteurs $K_6$, $K_7$ s'effectue en mode ZVS. Les interrupteurs $K_6$ et $K_7$ se ferment, tandis que les interrupteurs $K_1$ et $K_4$ s'ouvrent.

De l'instant temporel $t_3$ à l'instant temporel $t_{3b}$, le signe du courant $I_L$ conduit à une diminution de la tension piézoélectrique totale $V_p$. La tension piézoélectrique totale $V_p$ passe donc de $V_{in}+V_{out}$ à $V_{in}-V_{out}$. Seule la tension $V_{pb}$ a besoin d'être modifiée, et doit passer de $+V_{out}$ à $-V_{out}$, ce qu'elle fait naturellement avec la diminution de la tension piézoélectrique totale $V_p$, tandis que la tension $V_{pa}$ reste constante et fixée à $+V_{in}$ via le maintien des interrupteurs $K_6$ et $K_7$ fermés.

Durant la deuxième étape de la troisième phase III, à charge sensiblement constante, seuls les interrupteurs $K_6$ et $K_7$ sont alors commandés en position fermée.

En l'instant temporel $t_{3b}$, la tension $V_{pa}$ et la tension $V_{pb}$ sont donc déjà repositionnées sur les valeurs du palier de tension suivant, et la fermeture des interrupteurs $K_2$, $K_3$ s'effectue en mode ZVS. Si les interrupteurs $K_2$ et $K_3$ disposent d'une diode inverse intrinsèque ou d'une diode additionnelle placée en parallèle, leur mise en conduction peut se faire naturellement au regard du signe du courant. Les interrupteurs $K_6$, $K_7$ étaient déjà fermés. A l'instant temporel $t_{3b}$, les interrupteurs $K_2$ et $K_3$ se ferment ou deviennent passants.

De l'instant temporel $t_{3b}$ à l'instant temporel $t_4$, correspondant à une quatrième phase IV, les interrupteurs $K_2$, $K_3$, $K_6$ et $K_7$ sont passants ou fermés. La tension piézoélectrique totale $V_p$ est égale à $V_{in}-V_{out}$. Une puissance positive est tirée sur la tension d'entrée $V_{in}$ en même temps qu'une puissance positive est fournie à la tension de sortie $V_{out}$.

De l'instant temporel $t_4$ à l'instant temporel $t_5$, correspondant à une cinquième phase V, le signe du courant $I_L$ conduit à une diminution de la tension piézoélectrique totale $V_p$. La tension piézoélectrique totale $V_p$ passe donc de $+V_{in}-V_{out}$ à $-V_{out}$. Seule la tension $V_{pa}$ a besoin d'être modifiée, et passe de $+V_{in}$ à 0, ce qu'elle fait naturellement avec la diminution de la tension piézoélectrique totale $V_p$, tandis que la tension $V_{pb}$ reste constante et fixée à $-V_{out}$ via le maintien des interrupteurs $K_2$ et $K_3$ passants (soit en maintenant une commande de fermeture, soit naturellement via leur diode inverse intrinsèque, soit encore via une diode parallèle additionnelle).

Durant cette cinquième phase V, à charge sensiblement constante, seuls les interrupteurs $K_2$ et $K_3$ sont alors en position fermée.

En l'instant temporel $t_5$, l'interrupteur complémentaire $K_9$ connecté directement entre les premières extrémités 16 est fermé, et la tension $V_{pa}$ est alors positionnée à 0, tandis que la tension $V_{pb}$ reste constante et fixée à $-V_{out}$ via le maintien des interrupteurs $K_2$ et $K_3$ passants (soit en maintenant une commande de fermeture, soit naturellement via leur diode inverse intrinsèque, soit encore via une diode parallèle additionnelle).

De l'instant temporel $t_5$ à l'instant temporel $t_{5b}$, correspondant à une sixième phase VI, les interrupteurs $K_2$ et $K_3$ ainsi que l'interrupteur complémentaire $K_9$, sont passants ou fermés. La tension piézoélectrique totale $V_p$ est égale à $-V_{out}$. Une puissance positive est fournie à la tension de sortie $V_{out}$.

A la fin de la sixième phase VI, en l'instant temporel $t_{5b}$, l'interrupteur complémentaire $K_9$ connecté directement entre les premières extrémités 16 est ouvert, afin de laisser la tension $V_{pa}$ passer naturellement de 0 à $-V_{in}$, lors de la phase suivante à charge sensiblement constante, à savoir la première phase I du cycle suivant.

**Configuration très élévateur TE ($V_{out} > 2.V_{in}$) (exemple TE1)**

Sur la figure 4, de l'instant temporel $t_{5b}$ précédent à l'instant temporel $t_1$, correspondant à la première phase I, la tension piézoélectrique totale $V_p$ passe de $-V_{in}+V_{out}$ à $V_{in}$, avec une excursion à la tension $V_{ZVS}$ égale à $V_{in}+V_{out}$ en l'instant temporel $t_0$ (ou l'instant temporel $t_6$) compris entre les instants temporels $t_{5b}$ et $t_1$. Cette excursion de tension permet de passer du palier de tension piézoélectrique totale $V_p$ égal à $-V_{in}+V_{out}$ au palier de tension piézoélectrique totale $V_p$ égal à $V_{in}$ en commutation ZVS au niveau des interrupteurs.

Ce passage se fait en deux étapes, une première étape de l'instant temporel $t_{5b}$ précédent à l'instant temporel $t_0$ (ou l'instant temporel $t_6$) pour passer de la tension piézoélectrique totale $V_p$ égale à $-V_{in}+V_{out}$ à la tension piézoélectrique totale $V_p$ égale à $+V_{in}+V_{out}$, puis une seconde étape de l'instant temporel $t_0$ à l'instant temporel $t_1$ pour passer de la tension piézoélectrique totale $V_p$ égale à $+V_{in}+V_{out}$ à la tension piézoélectrique totale $V_p$ égale à $+V_{in}$.

Lors de cette première phase I, le signe du courant $I_L$ circulant dans les éléments piézoélectriques 15 conduit à une augmentation de de la tension piézoélectrique totale $V_p$ durant la première étape jusqu'à l'instant temporel $t_0$, puis à une diminution de la tension piézoélectrique totale $V_p$ durant la deuxième étape de l'instant temporel $t_0$ à l'instant temporel $t_1$.

Durant la première étape, seule la tension $V_{pa}$ a besoin d'être modifiée, et doit passer de $-V_{in}$ à $+V_{in}$, la tension piézoélectrique totale $V_p$ passant de $-V_{in}+V_{out}$ à $+V_{in}+V_{out}$, ce qu'elle fait naturellement avec l'augmentation de la tension piézoélectrique totale $V_p$, tandis que la tension $V_{pb}$ reste constante et fixée à $+V_{out}$ via le maintien des interrupteurs $K_1$ et $K_4$ passants (soit en maintenant une commande de fermeture, soit naturellement via leur diode inverse intrinsèque, soit encore via une diode parallèle additionnelle).

Durant la première étape de la première phase I, à charge sensiblement constante, seuls les interrupteurs $K_1$ et $K_4$ sont alors passants ou commandés en position fermée.

En l'instant temporel $t_0$, la tension $V_{pa}$ et la tension $V_{pb}$ sont donc pré-positionnées sur respectivement $+V_{in}$ et $+V_{out}$, et la fermeture des interrupteurs $K_6$, $K_7$ s'effectue en mode ZVS. Les interrupteurs $K_6$ et $K_7$ se ferment, tandis que les interrupteurs $K_1$ et $K_4$ s'ouvrent.

De l'instant temporel $t_0$ à l'instant temporel $t_1$, le signe du courant $I_L$ conduit à une diminution de la tension piézoélectrique totale $V_p$. La tension piézoélectrique totale $V_p$ passe donc de $+V_{in}+V_{out}$ à $+V_{in}$. Seule la tension $V_{pb}$ a besoin d'être modifiée, et doit passer de $+V_{out}$ à 0, ce qu'elle fait naturellement avec la diminution de la tension piézoélectrique totale $V_p$, tandis que la tension $V_{pa}$ reste constante et fixée à $+V_{in}$ via le maintien des interrupteurs $K_6$ et $K_7$ fermés.

Durant la deuxième étape de la première phase I, à charge sensiblement constante, seuls les interrupteurs $K_6$ et $K_7$ sont alors commandés en position fermée.

En l'instant temporel $t_1$, l'interrupteur complémentaire $K_9$ connecté directement entre les deuxièmes extrémités 18 est passants ou commandés en position fermée, et la tension $V_{pb}$ est alors positionnée à 0, tandis que la tension $V_{pa}$ reste constante et fixée à $+V_{in}$ via le maintien des interrupteurs $K_6$ et $K_7$ fermés.

De l'instant temporel $t_1$ à l'instant temporel $t_2$, correspondant à la deuxième phase II, les interrupteurs $K_6$ et $K_7$, ainsi que l'interrupteur complémentaire $K_9$, sont passants ou fermés. La tension piézoélectrique totale $V_p$ est égale à $+V_{in}$.

De l'instant temporel $t_2$ à l'instant temporel $t_3$, correspondant à la troisième phase III, le signe du courant $I_L$ conduit à une diminution de la tension piézoélectrique totale $V_p$. La tension piézoélectrique totale $V_p$ passe donc de $V_{in}$ à $-V_{in}$. Seule la tension $V_{pa}$ a besoin d'être modifiée, et doit passer de $+V_{in}$ à $-V_{in}$, ce qu'elle fait naturellement avec la diminution de la tension piézoélectrique totale $V_p$, tandis que la tension $V_{pb}$ reste constante et fixée à 0 via le maintien de l'interrupteur complémentaire $K_9$ fermé ou passant.

Durant cette troisième phase III, à charge sensiblement constante, seul l'interrupteur complémentaire $K_9$ est alors passant ou commandé en position fermée.

En l'instant temporel $t_3$, la tension $V_{pa}$ est donc déjà repositionnée sur la valeur du palier de tension suivant, et la fermeture des interrupteurs $K_5$, $K_8$ s'effectue en mode ZVS.

De l'instant temporel $t_3$ à l'instant temporel $t_4$, correspondant à la quatrième phase IV, les interrupteurs $K_5$ et $K_8$, ainsi que l'interrupteur complémentaire $K_9$, sont passants ou fermés. La tension piézoélectrique totale $V_p$ est égale à $-V_{in}$. Une puissance positive est tirée sur la tension d'entrée $V_{in}$.

A la fin de la quatrième phase IV, en l'instant temporel $t_4$, l'interrupteur complémentaire $K_9$ connecté directement entre les deuxièmes extrémités 18 est ouvert, afin de laisser la tension $V_{pb}$ passer naturellement de 0 à $+V_{out}$, lors de la phase suivante à charge sensiblement constante.

De l'instant temporel $t_4$ à l'instant temporel $t_5$, correspondant à la cinquième phase V, le signe du courant $I_L$ conduit à une augmentation de la tension piézoélectrique totale $V_p$. La tension piézoélectrique totale $V_p$ passe donc de $-V_{in}$ à $-V_{in}+V_{out}$. Seule la tension $V_{pb}$ a besoin d'être modifiée, et doit passer de 0 à $+V_{out}$, ce qu'elle fait naturellement avec l'augmentation de la tension piézoélectrique totale $V_p$, tandis que la tension $V_{pa}$ reste constante et fixée à $-V_{in}$ via le

maintien des interrupteurs $K_5$ et $K_8$ fermés.

Durant cette cinquième phase V, à charge sensiblement constante, seuls les interrupteurs $K_5$ et $K_8$ sont alors commandés en position fermée.

En l'instant temporel $t_5$, la tension $V_{pa}$ et la tension $V_{pb}$ sont donc déjà repositionnées sur les valeurs du palier de tension suivant, et la fermeture des interrupteurs $K_1$, $K_4$ s'effectue en mode ZVS. Si les interrupteurs $K_1$ et $K_4$ disposent d'une diode inverse intrinsèque ou d'une diode additionnelle placée en parallèle, leur mise en conduction peut se faire naturellement au regard du signe du courant. Les interrupteurs $K_5$, $K_8$ étaient déjà fermés.

De l'instant temporel $t_5$ à l'instant temporel $t_{5b}$, correspondant à la sixième phase VI, les interrupteurs $K_1$, $K_4$, $K_5$ et $K_8$ sont passants ou fermés. La tension piézoélectrique totale $V_p$ égale à $-V_{in}+V_{out}$. Une puissance positive est tirée sur la tension d'entrée $V_{in}$ en même temps qu'une puissance positive est fournie à la tension de sortie $V_{out}$.

L'homme du métier observera que dans cet exemple le pilotage mis en œuvre évite de reprendre inutilement de l'énergie sur la tension de sortie $V_{out}$ durant la quatrième phase IV à tension sensiblement constante où la tension piézoélectrique totale $V_p$ est égale à $-V_{in}$.

Enfin, l'homme du métier notera que la tension $V_{pb}$ ne passe plus par la valeur $-V_{out}$, ce qui permet de supprimer les interrupteurs $K_2$ et $K_3$ dans l'exemple du convertisseur 10 de la figure 3 par rapport à celui de la figure 1, et donc de faire l'économie de deux interrupteurs.

**Autres configurations**

Selon une autre configuration très élévateur, non représentée, la tension $V_{pb}$ ne passe plus par la valeur $+V_{out}$, ce qui permet de supprimer les interrupteurs $K_1$ et $K_4$ par rapport au convertisseur 10 de la figure 1, et donc de faire l'économie de deux interrupteurs. Autrement dit, selon cette autre configuration très élévateur, en partant du convertisseur 10 de la figure 1, les interrupteurs $K_1$ et $K_4$ sont supprimés, au lieu des interrupteurs $K_2$ et $K_3$ dans l'exemple du convertisseur 10 de la figure 3.

Selon une première configuration très abaisseur TA1, non représentée, l'interrupteur complémentaire $K_9$ est connecté directement entre les premières extrémités 16, et la tension $V_{pa}$ ne passe plus par la valeur $-V_{in}$, ce qui permet de supprimer les interrupteurs $K_5$ et $K_8$ par rapport au convertisseur 10 de la figure 1, et donc de faire l'économie de deux interrupteurs.

Selon une deuxième configuration très abaisseur TA2, non représentée, l'interrupteur complémentaire $K_9$ est connecté directement entre les premières extrémités 16, et la tension $V_{pa}$ ne passe plus par la valeur $+V_{in}$, ce qui permet de supprimer les interrupteurs $K_6$ et $K_7$ par rapport au convertisseur 10 de la figure 1, et donc de faire l'économie de deux interrupteurs. Autrement dit, selon cette deuxième configuration très abaisseur TA2, en partant du convertisseur 10 de la figure 1, les interrupteurs $K_6$ et $K_7$ sont supprimés, au lieu des interrupteurs $K_5$ et $K_8$ dans l'exemple du convertisseur 10 de la première configuration très abaisseur TA1.

L'homme du métier comprendra alors que cette économie de deux interrupteurs est valable pour toutes les configurations très élévateur et très abaisseur. Autrement dit, dans chacune des configurations très élévateur et très abaisseur, les premières branches de commutation 32 comportent de préférence un seul premier interrupteur 36 ou bien les deuxièmes branches de commutation 42 comportent de préférence un seul deuxième interrupteur 46.

Typiquement, dans chaque configuration très élévateur, les deuxièmes branches de commutation 42 comportent de préférence un seul deuxième interrupteur 46, et l'interrupteur complémentaire 28 est connecté directement entre les deuxièmes extrémités 18.

De manière analogue, dans chaque configuration très abaisseur, les premières branches de commutation 32 comportent de préférence un seul premier interrupteur 36, et l'interrupteur complémentaire 28 est connecté directement entre les premières extrémités 16.

L'homme du métier comprendra aussi que dans une configuration abaisseur ($V_{in}/2 < V_{out} < V_{in}$) ou élévateur ($V_{in} < V_{out} < 2V_{in}$) respective, l'interrupteur complémentaire 28 est bidirectionnel en tension. Cet interrupteur complémentaire 28 est, par exemple, naturellement bidirectionnel en tension (micro-switch, thyristor) ou encore un assemblage quelconque de transistors et/ou de diodes. L'interrupteur complémentaire 28 est, par exemple, réalisé sous forme de la mise en position tête bêche de deux sous-interrupteurs monodirectionnels en tension et placés en série, chaque sous-interrupteur ayant en outre optionnellement une diode inverse, soit intrinsèque à un transistor respectif, soit additionnelle et placée en parallèle dudit transistor. Le cas échéant, un des deux sous-interrupteurs est commandable à l'état fermé en anticipation, alors que l'autre devient passant à l'instant temporel souhaité (soit en appliquant une commande de fermeture ; soit naturellement via sa diode inverse intrinsèque, soit encore via une diode parallèle additionnelle).

Dans une configuration très abaisseur ($V_{out} < V_{in}/2$) ou très élévateur ($V_{in} < V_{out}/2$) respective, l'interrupteur complémentaire 28 est bidirectionnel en tension ; ou encore monodirectionnel en tension, tel que de même nature que les interrupteurs 36, 46.

Ainsi, le convertisseur d'énergie électrique 10 selon l'invention permet d'éviter que la tension piézoélectrique totale $V_p$ passe par un palier de tension $V_{in}+V_{out}$ ou $-V_{in}-V_{out}$ qui n'est pas complètement bénéfique puisqu'il conduit soit à redonner de l'énergie à l'entrée, soit d'en reprendre à la sortie et qui par ailleurs impose une excursion importante de la tension piézoélectrique totale $V_p$.

Le pilotage du convertisseur 10 privilégie alors, pour la tension piézoélectrique totale $V_p$, les paliers $V_{in}$-$V_{out}$ et $V_{out}$-$V_{in}$ qui bénéficient à la fois à l'entrée et à la sortie et dont la valeur absolue est relativement limitée : $|V_{in}$-$V_{out}| <$ Max $(V_{in}, V_{out})$.

Avantageusement, pour que ces deux paliers $V_{in}$-$V_{out}$ et $V_{out}$-$V_{in}$ soient pleinement bénéfiques, il est préférable au cours du cycle de résonance, que l'un ait lieu avant l'instant temporel $t_3$ (palier $V_b$) et l'autre après cet instant temporel $t_3$ (palier $V_a$ ou $V_c$).

En complément, l'interrupteur complémentaire 28 permet en outre de connecter directement entre elles les premières extrémités 16 ou deuxième extrémités 18 entre-elles à un instant temporel où la différence de potentiel entres ces extrémités est nulle et dans le même temps de respecter, durant une phase à charge sensiblement constante, la condition facultative selon laquelle est commandé en position fermée en même temps au plus un interrupteur respectif parmi les interrupteurs 36A, 46A connectés directement au premier ensemble piézoélectrique 12A et au plus un interrupteur respectif parmi les interrupteurs 36B, 46B connectés directement au deuxième ensemble piézoélectrique 12B, tous les autres interrupteurs 36, 46 des premières et deuxièmes branches de commutation 32, 42 étant commandés en position ouverte.

Selon ce complément facultatif, l'interrupteur complémentaire 28 permet alors d'offrir des valeurs additionnelles possibles pour la tension piézoélectrique totale $V_p$ aux bornes du couple d'ensembles piézoélectriques 12A, 12B, tout en assurant des commutations en ZVS et en évitant l'introduction d'une composante de mode commun.

En effet, à titre d'exemple, pour la tension $V_{pa}$ entre les premières extrémités 16, si le précédent palier de la tension $V_{pa}$ présentait une valeur égale $V_{in}$ avec les interrupteurs $K_6$ et $K_7$ fermés, lors de l'ouverture desdits interrupteurs $K_6$ et $K_7$, et si la tension piézoélectrique totale $V_p$ décroit, la tension $V_{pa}$ va décroitre vers 0, mais ceci va se produire via une augmentation du potentiel $V_{pa2}$ et une diminution du potentiel $V_{pa1}$ jusqu'à ce que les potentiels se croisent en $V_{in}/2$. Or maintenir les interrupteurs $K_6$ et $K_7$ fermés pour laisser les potentiels $V_{pa1}$ et $V_{pa2}$ se rejoindre en 0 ou en $V_{in}$ entrainerait l'injection d'une composante de mode commun sur la sortie. L'interrupteur complémentaire 28 connecté directement entre les premières extrémités 16 permet alors d'y remédier, tout évitant l'injection de cette composante de mode commun sur la sortie.

En pratique, que ce soit pour la tension $V_{pa}$ ou la tension $V_{pb}$, si le palier de tension précédent présente une valeur non nulle, alors la valeur nulle serait obtenue à $V_{pa1}=V_{pa2}=V_{in}/2$ pour la tension $V_{pa}$ et à $V_{pb1}=V_{pb2}=V_{out}/2$ pour la tension $V_{pb}$. L'interrupteur complémentaire 28 connecté directement entre les premières extrémités 16 permet alors de maintenir un état à la valeur nulle pour la tension $V_{pa}$, et peut typiquement être commandé à l'état fermé au passage par 0 en $V_{pa1}=V_{pa2}=V_{in}/2$. De manière analogue, l'interrupteur complémentaire 28 connecté directement entre les deuxièmes extrémités 18 permet de maintenir un état à la valeur nulle pour la tension $V_{pb}$, et peut typiquement être commandé à l'état fermé au passage par 0 en $V_{pb1}=V_{pb2}=V_{out}/2$.

En complément facultatif, dans les exemples des figures 6 à 10, le convertisseur 10 comprend en outre au moins un circuit d'aide à la commutation 50, chaque circuit d'aide à la commutation 50 étant connecté à un point milieu respectif parmi les premier(s) 38 et deuxième(s) 48 points milieux, chaque circuit d'aide à la commutation 50 étant configuré pour, via la circulation d'un courant préalablement reçu, décharger une capacité parasite d'au moins un interrupteur 36, 46 du pont de commutation 30, 40 respectif auquel il est connecté, et respectivement charger au moins une capacité parasite d'un autre interrupteur 36, 46 dudit pont de commutation 30, 40.

Dans les exemples des figures 6 et 9, le convertisseur 10 comprend un unique circuit d'aide à la commutation 50 connecté au premier pont de commutation 30 ou bien au deuxième pont de commutation 40. Dans l'exemple de la figure 6, l'unique circuit d'aide à la commutation 50 est connecté au deuxième pont de commutation 40. Dans l'exemple de la figure 9, l'unique circuit d'aide à la commutation 50 est connecté au premier pont de commutation 30.

Dans les exemples des figures 6 et 9, le deuxième pont de commutation 40 comporte deux deuxièmes branches de commutation 42, respectivement le premier pont de commutation 30 comporte deux premières branches de commutation 32 ; et le circuit d'aide à la commutation 50 est alors connecté entre les points milieux respectifs 38, 48 des deux branches de commutation 32, 42 dudit pont 30, 40. Dans l'exemple de la figure 6, le circuit d'aide à la commutation 50 est alors connecté entre les deuxièmes points milieux 48 des deux deuxièmes branches de commutation 42 du deuxième pont de commutation 40. De manière analogue, dans l'exemple de la figure 9, le circuit d'aide à la commutation 50 est alors connecté entre les premiers points milieux 38 des deux premières branches de commutation 32 du premier pont de commutation 30.

En variante, non représentée, le convertisseur 10 comprend deux circuits d'aide à la commutation 50, un premier circuit d'aide à la commutation étant connecté au premier pont de commutation 30 et un deuxième circuit d'aide à la commutation étant connecté au deuxième pont de commutation 40.

Selon cette variante, l'homme du métier comprendra que chaque circuit d'aide à la commutation 50 est susceptible d'être connecté entre les points milieux respectifs 38, 48 des deux branches de commutation 32, 42.

Chaque circuit d'aide à la commutation 50 est configuré, via la circulation d'un courant $I_{CALC}$ préalablement reçu, pour décharger au moins une capacité parasite d'un interrupteur 36, 46, de préférence un interrupteur à fermer, du pont de commutation 30, 40 respectif auquel il est connecté ; respectivement pour charger au moins une capacité parasite d'un autre interrupteur 36, 46, de préférence un interrupteur à ouvrir ou à maintenir ouvert, dudit pont de commutation 30, 40.

Chacun des interrupteurs dudit pont de commutation 30 est ouvert lors de la circulation, par le circuit d'aide à la commutation 50, du courant préalablement reçu.

Suite à cette circulation de courant, le/les interrupteur(s) 36, 46 dont la capacité parasite a été déchargée par le circuit d'aide à la commutation 50 est/sont fermés. Le/les autre(s) interrupteur(s) 36, 46 dont la capacité parasite a été chargée par le circuit d'aide à la commutation 50 reste ouvert.

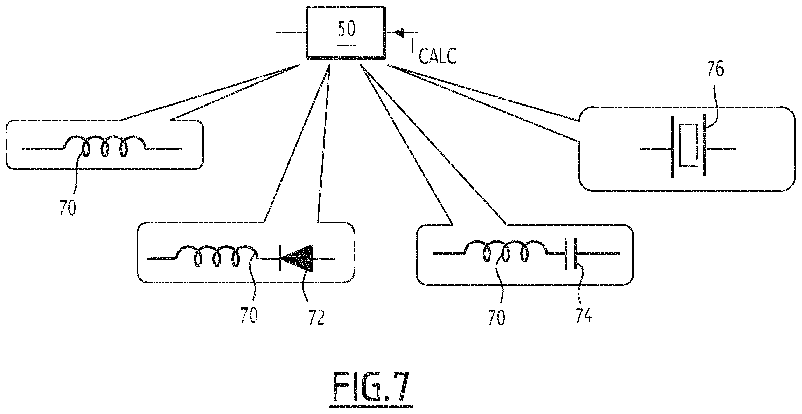

Chaque circuit d'aide à la commutation 50 comporte par exemple une inductance 70 ; ou un premier ensemble formé de l'inductance 70 et d'une diode 72 connectées en série ; ou un deuxième ensemble formé de l'inductance 70 et d'un condensateur 74 connectés en série ; ou encore un élément piézoélectrique additionnel 76, comme représenté sur la figure 7.

Chaque circuit d'aide à la commutation 50 est par exemple une inductance 70, l'inductance 70 étant de préférence constituée d'une bobine et d'un circuit magnétique. En variante, chaque circuit d'aide à la commutation 50 est en forme du premier ensemble de l'inductance 70 et de la diode 72 connectées en série, et de préférence constitué dudit premier ensemble de l'inductance 70 et de la diode 72. En variante encore, chaque circuit d'aide à la commutation 50 est en forme du deuxième ensemble de l'inductance 70 et du condensateur 74 connectés en série, et de préférence constitué dudit deuxième ensemble de l'inductance 70 et du condensateur 74. En variante encore, chaque circuit d'aide à la commutation 50 est en forme de l'élément piézoélectrique additionnel 76, et de préférence constitué de l'élément piézoélectrique additionnel 76.

Dans l'exemple de réalisation où le circuit d'aide à la commutation 50 est en forme de l'inductance 70 seule, l'inductance 70 voit son courant croitre sur une demi-période, i.e. lorsque la tension à ses bornes est positive ; puis son courant décroitre sur l'autre demi-période, i.e. lorsque la tension à ses bornes est négative. Cet exemple de réalisation du circuit d'aide à la commutation 50 nécessite de préférence que la tension aux bornes de l'inductance 70 soit de moyenne sensiblement nulle, au risque sinon d'avoir une dérive en courant. Si le circuit d'aide à la commutation 50 est connecté au deuxième pont 40, en particulier entre les deuxièmes points milieux 48, la tension aux bornes de l'inductance 70 est la tension $V_{pb}$. Corollairement, si le circuit d'aide à la commutation 50 est connecté au premier pont 30, en particulier entre les premiers points milieux 38, la tension aux bornes de l'inductance 70 est la tension $V_{pa}$.

La variante où le circuit d'aide à la commutation 50 est en forme de l'inductance 70 et de la diode 72 connectées en série, permet de charger l'inductance 70 uniquement sur une demi-période avec la bonne polarité, en particulier pour des cycles où le courant $I_{CALC}$ est reçu au cours d'une période temporelle avec une seule polarité. En particulier, la diode 72 permet alors d'éviter de charger l'inductance 70 avec un courant inverse. Ce fonctionnement unidirectionnel en courant permet aussi de réduire le courant efficace vu par l'inductance 70 et donc les pertes. Par ailleurs, le circuit d'aide à la commutation 50 selon cette variante n'est pas sensible à la présence d'une composante continue à partir du moment où la composante continue est dans le sens d'un blocage de la diode 72.

La variante où le circuit d'aide à la commutation 50 est en forme de l'inductance 70 et du condensateur 74 connectés en série, permet - par rapport à l'exemple de l'inductance 70 seule - de réduire, voire d'éliminer une composante continue éventuelle. Néanmoins, le condensateur 74 peut être assez volumineux. En effet, la tension aux bornes du condensateur 74 doit évoluer peu, i.e. dans une faible proportion, par rapport à la tension d'entrée $V_{in}$ ou à la tension de sortie $V_{out}$, par exemple avoir une amplitude inférieure à 50% de la tension d'entrée $V_{in}$ ou de sortie $V_{out}$.

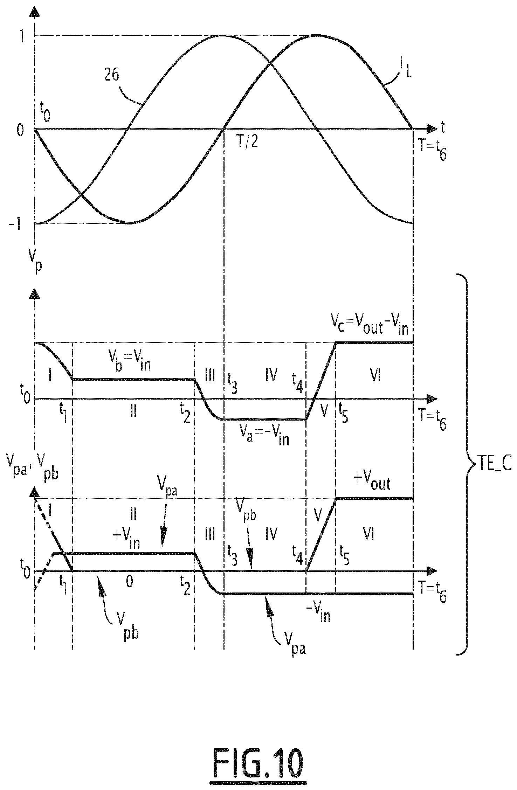

Selon la variante où le circuit d'aide à la commutation 50 est en forme de l'élément piézoélectrique additionnel 76, à partir du moment où le pilotage du convertisseur 10 s'effectue entre la fréquence de résonance et d'antirésonance de l'élément piézoélectrique additionnel 76, ce dernier se met à osciller et à produire un courant $I_{CALC}$ sensiblement en quadrature avec la tension à ses bornes, telle que la tension $V_{pb}$ si l'élément piézoélectrique additionnel 76 est connecté au deuxième pont 40 entre les deuxièmes points milieux 48, ou encore la tension $V_{pa}$ si l'élément piézoélectrique additionnel 76 est connecté au premier pont 30 entre les premiers points milieux 38. Le courant $I_{CALC}$ passe alors par un extrema autour de l'instant temporel t3 pour le cycle abaisseur A_C, ce qui permet d'assurer la fonction d'inversion de la tension $V_{pb}$ entre les instants temporels $t_2$ et $t_3$ ; ou similairement autour de l'instant temporel $t_0$ pour le cycle très élévateur TE_C décrit par la suite en regard de la figure 10, ce qui permet d'assurer la fonction d'inversion de la tension $V_{pa}$ entre les instants temporels $t_0$ et $t_1$.

L'élément piézoélectrique additionnel 76 est typiquement au moins 3 fois plus petit que le ou les éléments piézoélectriques 15 du convertisseur 10, l'élément piézoélectrique additionnel 76 n'ayant qu'à charger/décharger les capacités parasites des interrupteurs 36, 46. La capacité parasite des interrupteurs 36, 46 est en effet considérée comme étant au moins trois fois inférieure à la capacité de référence $C_0$ du ou des éléments piézoélectriques 15 du convertisseur 10. Cette variante où le circuit d'aide à la commutation 50 est en forme de l'élément piézoélectrique additionnel 76 est insensible à une éventuelle composante continue (quelle que soit sa polarité), et le circuit d'aide à la commutation 50 est apte à être connecté aussi bien au premier pont 30 (tension $V_{pa}$) qu'au deuxième pont 40 (tension $V_{pb}$).

Autrement dit, la capacité de référence de l'élément piézoélectrique additionnel 76 est au moins trois fois inférieure à la capacité de référence $C_0$ de chaque ensemble piézoélectrique 12 connecté entre des premier 38 et deuxième 48 points milieux respectifs.

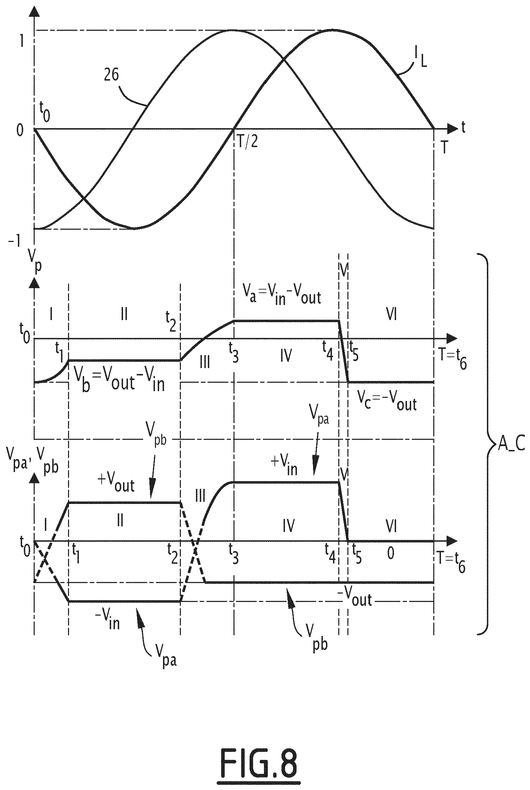

Le fonctionnement du convertisseur 10 dans l'exemple de la figure 6 va désormais être expliqué selon une configuration abaisseur de tension A_C en regard de la figure 8. La différence résultant du circuit d'aide à la commutation 50 selon l'aspect complémentaire porte sur les évolutions des tensions $V_{pa}$ et $V_{pb}$ entre les instants temporels $t_2$ et $t_3$ et entre les instants temporels $t_0$ et $t_1$ dans le cas la configuration abaisseur A_C, et plus particulièrement sur les zones représentées en trait pointillé sur la figure 8, ceci pour marquer la différence.

Le cycle de conversion du convertisseur 10 selon l'aspect complémentaire est décrit ci-après pour la configuration abaisseur A_C, en se focalisant sur les différences par rapport au cycle de conversion du convertisseur 10 de la figure 1 pour la même configuration abaisseur A.

Pour la configuration abaisseur A_C, entre les instants temporels $t_1$ et $t_2$, selon l'exemple de réalisation du circuit d'aide à la commutation 50, l'inductance 70 ou bien l'élément piézoélectrique additionnel 76 voit son courant $I_{CALC}$ augmenter, ceci sous la tension $V_{pb}$ égale à $V_{out}$. En l'instant temporel $t_2$, le courant $I_{CALC}$ est positif.

Juste avant l'instant temporel $t_2$, la tension piézoélectrique totale $V_p$ est égale à $V_{out}-V_{in}$, la tension $V_{pa}$ étant égale à $-V_{in}$, et la tension $V_{pb}$ étant égale à $+V_{out}$ ; et les interrupteurs $K_5$, $K_8$, $K_1$, $K_4$ sont fermés.

En l'instant temporel $t_2$, tous les interrupteurs qui étaient fermés s'ouvrent. Le courant $I_{CALC}$ charge alors les capacités parasites des interrupteurs $K_1$, $K_4$, pendant qu'il décharge les capacités parasites des interrupteurs $K_2$ et $K_3$. De même, au travers des ensembles piézoélectriques 12 dont la tension évolue lentement, le courant $I_{CALC}$ charge partiellement les capacités parasites des interrupteurs $K_5$, $K_8$, pendant qu'il décharge partiellement les capacités parasites des interrupteurs $K_6$, $K_7$. La tension $V_{pb}$ évolue ainsi de $+V_{out}$ à $-V_{out}$, tandis que la tension $V_{pa}$ évolue sensiblement de $-V_{in}$ à $-V_{in}+2V_{out}$ plus l'évolution de la tension piézoélectrique totale $V_p$ depuis l'instant temporel $t_2$.

L'inversion de tension $V_{pb}$ est considérée achevée avant que la tension piézoélectrique totale $V_p$ atteigne le palier $V_a$ suivant. En effet, même si l'amplitude du courant $I_{CALC}$ dans le circuit d'aide à la commutation 50 est bien inférieure à l'amplitude du courant interne $I_L$ des éléments piézoélectriques 15 (par exemple au moins 3 fois inférieure pour limiter sa taille), celui-ci n'a néanmoins qu'à charger/décharger les capacités parasites des interrupteurs 36, 46 considérées bien inférieures à la capacité de référence $C_0$ des éléments piézoélectriques 15 (au moins un facteur 3). Par ailleurs, le courant $I_{CALC}$ dans le circuit d'aide à la commutation 50 se rapproche de sa valeur maximale en l'instant temporel $t_3$, alors que le courant interne $I_L$ se rapproche de 0 en ledit instant temporel $t_3$.

Une fois l'inversion complète de la tension $V_{pb}$ atteinte (passage de $V_{out}$ à $-V_{out}$), alors les interrupteurs $K_2$ et $K_3$ sont fermés de sorte à figer la tension $V_{pb}$, tandis que la tension $V_{pa}$ continue sa progression jusqu'à $V_{in}$ sous l'effet de l'augmentation naturelle de la tension piézoélectrique totale $V_p$.

En l'instant temporel $t_3$, les interrupteurs $K_6$ et $K_7$ sont fermés. Les interrupteurs $K_2$ et $K_3$ sont également fermés si cela n'avait pas été déjà fait avant, i.e. si la tension $V_{pb}$ n'avait pas encore atteint $-V_{out}$.

En complément, si les interrupteurs $K_2$ et $K_3$ comportent une diode inverse intrinsèque ou une diode additionnelle placée en parallèle, leur mise en conduction peut se faire naturellement au regard du signe du courant interne $I_L$ après l'instant temporel $t_3$, ou au regard du courant $I_{CALC}$ résiduel avant l'instant temporel $t_3$.

L'excursion en tension de la tension piézoélectrique totale $V_p$ est ainsi limitée entre les instants temporels $t_2$ et $t_4$, celle-ci allant de $V_{out}-V_{in}$ à $V_{in}-V_{out}$, au lieu d'aller de $V_{out}-V_{in}$ à $+V_{in}+V_{out}$ avec le convertisseur 10 de la figure 1 (dans le cas de la configuration abaisseur A pour assurer des commutations des interrupteurs 36, 46 à zéro de tension), soit une excursion de $2V_{in}-2V_{out}$ au lieu de $2V_{in}$, tout en assurant des commutations des interrupteurs 36, 46 à zéro de tension.

Les quatrième IV et cinquième V phases du cycle de conversion du convertisseur 10 selon l'aspect complémentaire sont ensuite inchangées par rapport à celles du cycle de conversion du convertisseur 10 de la figure 1.

Entre les instants temporels $t_5$ et $t_6$, selon l'exemple de réalisation du circuit d'aide à la commutation 50, l'inductance 70 ou bien l'élément piézoélectrique additionnel 76 voit son courant $I_{CALC}$ diminuer, ceci sous la tension $V_{pb}$ égale à $-V_{out}$. En l'instant temporel $t_6$, le courant $I_{CALC}$ est négatif.

Juste avant l'instant temporel $t_6$, la tension piézoélectrique totale $V_p$ est égale à $-V_{out}$, la tension $V_{pa}$ étant égale à 0, et la tension $V_{pb}$ étant égale à $-V_{out}$ ; et les interrupteurs $K_2$, $K_3$, ainsi que l'interrupteur complémentaire $K_9$, sont fermés.

En l'instant temporel $t_6$, tous les interrupteurs qui étaient fermés s'ouvrent. Le courant $I_{CALC}$ charge alors les capacités parasites des interrupteurs $K_2$ et $K_3$, pendant qu'il décharge les capacités parasites des interrupteurs $K_1$, $K_4$. De même, au travers des ensembles piézoélectriques 12 dont la tension évolue lentement, le courant $I_{CALC}$ décharge partiellement les capacités parasites des interrupteurs $K_5$, $K_8$.

Comme $V_{in}<2V_{out}$, la tension $V_{pa}$ atteint $-V_{in}$ avant que la tension $V_{pb}$ atteigne $V_{out}$, la tension $V_{pa}$ étant partie de 0 (valeur nulle aux bornes de l'interrupteur complémentaire $K_9$ fermé), tandis que la tension $V_{pb}$ est partie de $-V_{out}$. L'inversion de la tension $V_{pb}$ n'est alors que partielle, car dès que la tension $V_{pa}$ atteint $-V_{in}$, les interrupteurs $K_5$ et $K_8$ se ferment (par exemple, de par les diodes inverses qui deviennent passantes). Il faut alors attendre que la tension piézoélectrique totale $V_p$ atteigne le palier $V_b$ suivant, égal à $V_{out}-V_{in}$, en l'instant temporel $t_1$ pour que l'inversion de la tension $V_{pb}$ soit complète.

Une fois l'inversion complète de la tension $V_{pb}$ atteinte (passage de $-V_{out}$ à $+V_{out}$), alors les interrupteurs $K_1$ et $K_4$

sont fermés de sorte à figer la tension $V_{pb}$.

Là encore, l'excursion en tension de la tension piézoélectrique totale $V_p$ est ainsi limitée entre les instants temporels $t_5$ et $t_1$, celle-ci allant de $-V_{out}$ à $V_{out}-V_{in}$, au lieu d'aller de $-V_{in}-V_{out}$ à $V_{out}-V_{in}$ avec le convertisseur 10 de la figure 1 (dans le cas de la configuration abaisseur A pour assurer des commutations des interrupteurs 36, 46 à zéro de tension), soit une excursion de de $2V_{out}-V_{in}$ au lieu de $2V_{out}$, tout en assurant des commutations des interrupteurs 36, 46 à zéro de tension.

Les figures 9 et 10 illustrent une variante de réalisation du convertisseur 10 pour lequel le circuit d'aide à la commutation 50 est connecté au deuxième pont de commutation 40, par exemple entre les deuxièmes points milieux 48 des deux deuxièmes branches de commutation 42.

Le fonctionnement du convertisseur 10 dans l'exemple de la figure 9 va désormais être expliqué selon une configuration très élévateur de tension TE_C en regard de la figure 10. La différence résultant du circuit d'aide à la commutation 50 selon cet aspect complémentaire porte sur les évolutions des tensions $V_{pa}$ et $V_{pb}$ entre les instants temporels $t_0$ et $t_1$, et plus particulièrement sur les zones représentées en trait pointillé sur la figure 10, ceci pour marquer la différence.

Le cycle de conversion du convertisseur 10 selon cet aspect complémentaire est décrit ci-après pour la configuration très élévateur de tension TE_C, en se focalisant sur les différences par rapport au cycle de conversion du convertisseur 10 de la figure 3 pour la même configuration élévateur, notée TE à la figure 4.

Pour la configuration abaisseur A_C, décrite précédemment, c'était la tension $V_{pa}$ qui avait une polarité homogène sur chacune des deux demi-périodes avec une inversion de polarité entre les deux demi-périodes, et il était alors préférable de disposer le circuit d'aide à la commutation 50 du côté de la tension $V_{pa}$, i.e. connecté au premier pont de commutation 30, entre les premiers points milieux 38 respectifs.

Cette fois-ci, pour la configuration très élévateur TE_C, le circuit d'aide à la commutation 50 est disposé du côté de la tension $V_{pa}$, i.e. connecté au premier pont de commutation 30, entre les premiers points milieux 38 respectifs.

Pour la configuration très élévateur TE_C, entre les instants temporels $t_5$ et T (ou $t_0$), selon l'exemple de réalisation du circuit d'aide à la commutation 50, l'inductance 70 ou bien l'élément piézoélectrique additionnel 76 voit son courant $I_{CALC}$ diminuer, ceci sous la tension $V_{pa}$ égale à $-V_{in}$. En l'instant temporel T (ou $t_0$), le courant $I_{CALC}$ est négatif.

Juste avant l'instant temporel $t_0$, la tension piézoélectrique totale $V_p$ est égale à $V_{out}-V_{in}$, la tension $V_{pa}$ étant égale à $-V_{in}$, et la tension $V_{pb}$ étant égale à $V_{out}$ ; et les interrupteurs $K_5$, $K_8$, $K_1$, $K_4$ sont fermés.

En l'instant temporel $t_0$, tous les interrupteurs qui étaient fermés s'ouvrent. Le courant $I_{CALC}$ charge alors les capacités parasites des interrupteurs $K_5$, $K_8$, pendant qu'il décharge les capacités parasites des interrupteurs $K_6$, $K_7$. De même, au travers des ensembles piézoélectriques 12 dont la tension évolue lentement, le courant $I_{CALC}$ charge partiellement les capacités parasites des interrupteurs $K_1$, $K_4$. La tension $V_{pa}$ évolue ainsi de $-V_{in}$ à $+V_{in}$, tandis que la tension $V_{pb}$ évolue sensiblement de $V_{out}$ à $V_{out}-2V_{in}$ plus l'évolution de la tension piézoélectrique totale $V_p$ depuis l'instant temporel $t_0$.

L'inversion de tension $V_{pa}$ est considérée achevée avant que la tension piézoélectrique totale $V_p$ atteigne le palier $V_b$ suivant. En effet, même si l'amplitude du courant $I_{CALC}$ dans le circuit d'aide à la commutation 50 est bien inférieure à l'amplitude du courant interne $I_L$ des éléments piézoélectriques 15 (par exemple au moins 3 fois inférieure pour limiter sa taille), celui-ci n'a néanmoins qu'à charger/décharger les capacités parasites des interrupteurs 36, 46 considérées bien inférieures à la capacité de référence $C_0$ des éléments piézoélectriques 15 (au moins un facteur 3). Par ailleurs, le courant $I_{CALC}$ dans le circuit d'aide à la commutation 50 se rapproche de sa valeur minimale (son extremum négatif) en l'instant temporel $t_0$, alors que le courant interne $I_L$ se rapproche de 0 en ledit instant temporel $t_0$.

Une fois l'inversion complète de la tension $V_{pa}$ atteinte (passage de $-V_{in}$ à $+V_{in}$), alors les interrupteurs $K_6$ et $K_7$ sont fermés de sorte à figer la tension $V_{pa}$, tandis que la tension $V_{pb}$ continue sa progression jusqu'à 0 sous l'effet de la diminution naturelle de la tension piézoélectrique totale $V_p$.

Le reste du cycle de conversion du convertisseur 10 selon l'aspect complémentaire reste sensiblement inchangé par rapport au cycle de conversion du convertisseur 10 de la figure 3.

L'excursion en tension de la tension piézoélectrique totale $V_p$ est ainsi limitée entre les instants temporels $t_5$ et $t_1$, celle-ci allant de $V_{out}-V_{in}$ à $V_{in}$, au lieu d'aller de $+V_{in}+V_{out}$ à $V_{in}$ avec le convertisseur 10 de la figure 3 (dans le cas de la configuration très élévateur TE pour assurer des commutations des interrupteurs 36, 46 à zéro de tension), soit une excursion de $V_{out}-2V_{in}$ au lieu de $V_{out}$, tout en assurant des commutations des interrupteurs 36, 46 à zéro de tension.

En complément facultatif, lorsque le convertisseur 10 comprend deux circuits d'aide à la commutation 50, avec le premier circuit d'aide à la commutation connecté au premier pont de commutation 30 et le deuxième circuit d'aide à la commutation connecté au deuxième pont de commutation 40, les circuits d'aide à la commutation 50 étant alors agencés à la fois du côté de la tension $V_{pa}$ et du côté de la tension $V_{pb}$, les effets des deux circuits d'aide à la commutation 50 s'additionnent. Il faut juste choisir les circuit d'aide à la commutation 50 en fonction de la présence ou non d'une composante continue, et éventuellement selon le signe de cette composante continue s'il y en a une.

On conçoit ainsi que le convertisseur d'énergie électrique 10 selon cet aspect complémentaire offre un pilotage encore davantage amélioré de par le circuit d'aide à la commutation 50.

**Revendications**

1. Convertisseur d'énergie électrique (10) apte à convertir une tension d'entrée ($V_{in}$) en au moins une tension de sortie ($V_{out}$), le convertisseur (10) comprenant :

    - au moins un couple de premier (12A) et deuxième (12B) ensembles piézoélectriques, chaque ensemble piézoélectrique (12A,12B) comportant au moins un élément piézoélectrique (15),
    - un premier pont de commutation (30) comportant deux premières branches de commutation (32), chaque première branche de commutation (32) comportant au moins un premier interrupteur (36) ;
    - au moins un deuxième pont de commutation (40) comportant deux deuxièmes branches de commutation (42), chaque deuxième branche de commutation (42) comportant au moins un deuxième interrupteur (46) ;
    chaque ensemble piézoélectrique (12A,12B) comportant une première extrémité (16) connectée au premier pont de commutation (30) et une deuxième extrémité (18) connectée au deuxième pont de commutation (40) ;
    chaque premier interrupteur (36) étant connecté entre une borne (34) d'application de la tension d'entrée ($V_{in}$) et une première extrémité (16) respectives ;
    chaque deuxième interrupteur (46) étant connecté entre une borne (44) de fourniture de la tension de sortie ($V_{out}$) et une deuxième extrémité (18) respectives ;
    **caractérisé en ce qu'**il comprend en outre au moins un interrupteur complémentaire (28) connecté directement entre des extrémités (16 ; 18) d'un couple respectif de premier (12A) et deuxième (12B) ensembles piézoélectriques, lesdites extrémités (16 ; 18) reliées directement entre elles via un interrupteur complémentaire (28) respectif étant connectées à un même pont de commutation (30 ; 40) respectif, chaque interrupteur complémentaire (28) étant connecté uniquement aux extrémités (16 ; 18) du couple respectif de premier (12A) et deuxième (12B) ensembles piézoélectriques, et
    **en ce que** le convertisseur (10) est dépourvu de connexion directe entre chaque interrupteur complémentaire (28) et une borne (34) respective d'application de la tension d'entrée ($V_{in}$) d'une part, et dépourvu de connexion directe entre chaque interrupteur complémentaire (28) et une borne (44) respective de fourniture de la tension de sortie ($V_{out}$) d'autre part.

2. Convertisseur (10) selon la revendication 1, dans lequel le convertisseur (10) comprend deux interrupteurs complémentaires (28), un premier interrupteur complémentaire (28) étant connecté directement entre les premières extrémités (16) d'un couple respectif de premier (12A) et deuxième (12B) ensembles piézoélectriques, lesdites premières extrémités (16) étant connectées au premier pont de commutation (30) et un deuxième interrupteur complémentaire (28) étant connecté directement entre les deuxièmes extrémités (18) d'un couple respectif de premier (12A) et deuxième (12B) ensembles piézoélectriques, lesdites deuxièmes extrémités (18) étant connectées au deuxième pont de commutation (40).

3. Convertisseur (10) selon l'une quelconque des revendications précédentes, dans lequel le convertisseur d'énergie électrique (10) est apte à convertir la tension d'entrée ($V_{in}$) en plusieurs tensions de sortie ($V_{out\_j}$) distinctes, et comporte
    pour chaque tension de sortie ($V_{out\_j}$) respective :

    + un deuxième pont de commutation (40) respectif ;
    + un couple respectif de premier (12A) et deuxième (12B) ensembles piézoélectriques.

4. Convertisseur (10) selon l'une quelconque des revendications précédentes, dans lequel chaque ensemble piézoélectrique (12A,12B) est constitué selon l'une des constitutions parmi le groupe consistant en : un unique élément piézoélectrique (15) ; plusieurs éléments piézoélectriques (15) connectés en série ; plusieurs éléments piézoélectriques (15) connectés en parallèle ; et un agencement de plusieurs branches piézoélectriques parallèles, chaque branche comportant un ou plusieurs éléments piézoélectriques (15) connectés en série.

5. Convertisseur (10) selon l'une quelconque des revendications précédentes, dans lequel chaque première branche de commutation (32) est connectée entre deux bornes (34) d'application de la tension d'entrée ($V_{in}$) et comporte au moins deux premiers interrupteurs (36) connectés en série et reliés entre eux en un premier point milieu (38), chaque premier point milieu (38) étant alors connecté à une première extrémité (16) respective.

6. Convertisseur (10) selon l'une quelconque des revendications précédentes, dans lequel chaque deuxième branche de commutation (42) est connectée entre deux bornes (44) de fourniture d'une tension de sortie ($V_{out}$) respective et comporte au moins deux deuxièmes interrupteurs (46) connectés en série et reliés entre eux en un deuxième point

EP 4 191 853 B1

milieu (48), chaque deuxième point milieu (48) étant alors connecté à une deuxième extrémité (18) respective.

7. Système électronique de conversion d'énergie électrique (5) comprenant un convertisseur d'énergie électrique (10) et un dispositif électronique (20) de pilotage du convertisseur d'énergie électrique (10), **caractérisé en ce que** le convertisseur d'énergie électrique (10) est selon l'une quelconque des revendications précédentes.

8. Système (5) selon la revendication 7, dans lequel le dispositif électronique de pilotage (20) est configuré pour commander, lors d'un cycle respectif de résonance des ensembles piézoélectriques (12A,12B), une commutation de chacun des interrupteurs (36, 46) pour alterner des phases (II, IV, VI) à tension sensiblement constante aux bornes des ensembles piézoélectriques (12A,12B) et des phases (I, III, V) à charge sensiblement constante aux bornes desdits ensembles piézoélectriques (12A,12B), la tension sensiblement constante correspondant à une variation de tension inférieure à 20% de la tension d'entrée ou de sortie du convertisseur (10), et la charge sensiblement constante correspondant à un échange d'une charge avec l'extérieur qui est inférieur à 10% de la charge qui aurait été échangée avec l'extérieur si la tension avait été maintenue constante.

9. Système (5) selon la revendication 8, dans lequel le dispositif électronique de pilotage (20) est configuré en outre pour, lors d'au moins une phase (II, IV, VI) à tension sensiblement constante, commander au moins un interrupteur complémentaire (28) respectif en position fermée.

10. Système (5) selon la revendication 8 ou 9, dans lequel le dispositif électronique de pilotage (20) est configuré pour, lors de chaque phase (I, III, V) à charge sensiblement constante, commander en position fermée en même temps au plus un interrupteur respectif parmi les interrupteurs (36A, 46A) connectés directement au premier ensemble piézoélectrique (12A) et au plus un interrupteur respectif parmi les interrupteurs (36B, 46B) connectés directement au deuxième ensemble piézoélectrique (12B), et en position ouverte tous les autres interrupteurs (36, 46) des premières et deuxièmes branches de commutation (32, 42).

11. Système (5) selon les revendications 9 et 10, dans lequel, en l'absence de commande d'un interrupteur complémentaire (28) respectif en position fermée lors d'une phase (II, IV, VI) respective à tension sensiblement constante, la valeur ($V_a$, $V_b$, $V_c$) de la tension lors de la phase (II, IV, VI) à tension sensiblement constante est choisie parmi le groupe de valeurs consistant en : différence ($V_{in}$ - $V_{out}$) entre la valeur de la tension d'entrée ($V_{in}$) et celle de la tension de sortie ($V_{out}$) ; différence ($V_{out}$ - $V_{in}$) entre la valeur de la tension de sortie ($V_{out}$) et celle de la tension d'entrée ($V_{in}$) ; somme ($V_{in}$ + $V_{out}$) des valeurs des tensions d'entrée ($V_{in}$) et de sortie ($V_{out}$) ; et opposé de la somme (-$V_{in}$ -$V_{out}$) des valeurs des tensions d'entrée ($V_{in}$) et de sortie ($V_{out}$) ; et

avec la commande d'au moins un interrupteur complémentaire (28) respectif en position fermée lors d'une phase (II, IV, VI) respective à tension sensiblement constante, ledit groupe de valeurs comporte en outre : valeur de la tension d'entrée ($V_{in}$) ; opposé (-$V_{in}$) de la valeur de la tension d'entrée ($V_{in}$) ; valeur de la tension de sortie ($V_{out}$) ; opposé (-$V_{out}$) de la valeur de la tension de sortie ($V_{out}$) ; et valeur nulle.

12. Système (5) selon la revendication 11, dans lequel ledit groupe de valeurs comporte la valeur de la tension d'entrée ($V_{in}$) et l'opposé (-$V_{in}$) de la valeur de la tension d'entrée ($V_{in}$) si le convertisseur (10) comprend un interrupteur complémentaire (28) respectif connecté directement entre les deuxièmes extrémités (18) d'un couple respectif de premier (12A) et deuxième (12B) ensembles piézoélectriques, lesdites deuxièmes extrémités (18) étant connectées au deuxième pont de commutation (40) ;

ledit groupe de valeurs comporte la valeur de la tension de sortie ($V_{out}$) et l'opposé (-$V_{out}$) de la valeur de la tension de sortie ($V_{out}$) si le convertisseur (10) comprend un interrupteur complémentaire (28) respectif connecté directement entre les premières extrémités (16) d'un couple respectif de premier (12A) et deuxième (12B) ensembles piézoélectriques, lesdites premières extrémités (16) étant connectées au premier pont de commutation (30) ;
ledit groupe de valeurs comporte la valeur nulle si le convertisseur (10) est selon la revendication 2.

13. Procédé de pilotage d'un convertisseur d'énergie électrique (10), le convertisseur (10) étant selon l'une quelconque des revendications 1 à 9, le procédé étant mis en œuvre par un dispositif électronique de pilotage (20) et comprenant la commande, lors d'un cycle respectif de résonance des ensembles piézoélectriques (12A,12B), d'une commutation de chacun des interrupteurs (36, 46) pour alterner des phases (II, IV, VI) à tension sensiblement constante aux bornes des ensembles piézoélectriques (12A, 12B) et des phases (I, III, V) à charge sensiblement constante aux bornes desdits ensembles piézoélectriques (12A,12B), la tension sensiblement constante correspondant à une variation de tension inférieure à 20% de la tension d'entrée ou de sortie du convertisseur (10), et la charge sensiblement constante correspondant à un échange d'une charge avec l'extérieur qui est inférieur à 10% de la charge qui aurait été échangée avec l'extérieur si la tension avait été maintenue constante,

**caractérisé en ce que**, lors d'au moins une phase (II, IV, VI) à tension sensiblement constante, au moins un interrupteur complémentaire (28) respectif est commandé en position fermée, et
**en ce que** le convertisseur (10) est dépourvu de connexion directe entre chaque interrupteur complémentaire (28) et une borne (34) respective d'application de la tension d'entrée ($V_{in}$) d'une part, et dépourvu de connexion directe entre chaque interrupteur complémentaire (28) et une borne (44) respective de fourniture de la tension de sortie ($V_{out}$) d'autre part.

**14.** Procédé selon la revendication 13, dans lequel, lors de chaque phase (I, III, V) à charge sensiblement constante, au plus un interrupteur respectif parmi les interrupteurs (36A, 46A) connectés directement au premier ensemble piézoélectrique (12A) et au plus un interrupteur respectif parmi les interrupteurs (36B, 46B) connectés directement au deuxième ensemble piézoélectrique (12B) sont commandés en position fermée en même temps, et tous les autres interrupteurs (36, 46) des premières et deuxièmes branches de commutation (32, 42) sont commandés en position ouverte.

**Patentansprüche**

**1.** Stromwandler (10), der geeignet ist, um eine Eingangsspannung ($V_{in}$) in mindestens eine Ausgangsspannung ($V_{out}$) umzuwandeln, der Stromwandler (10) umfassend:

- mindestens ein Paar aus einer ersten (12A) und einer zweiten (12B) piezoelektrischen Anordnung, jede piezoelektrische Anordnung (12A, 12B) umfassend mindestens ein piezoelektrisches Element (15),
- eine erste Schaltbrücke (30), umfassend zwei erste Schaltzweige (32), jeder erste Schaltzweig (32) umfassend mindestens einen ersten Schalter (36);
- mindestens eine zweite Schaltbrücke (40), umfassend zwei zweiten Schaltzweige (42), jeder zweite Schaltzweig (42) umfassend mindestens einen zweiten Schalter (46);
jede piezoelektrische Anordnung (12A, 12B) umfassend ein erstes Ende (16), das mit der ersten Schaltbrücke (30) verbunden ist, und ein zweites Ende (18), das mit der zweiten Schaltbrücke (40) verbunden ist;
wobei jeder erste Schalter (36) jeweils zwischen einem Anschluss (34) zum Anlegen der Eingangsspannung ($V_{in}$) und einem ersten Ende (16) verbunden ist;
wobei jeder zweite Schalter (46) jeweils zwischen einem Anschluss (44) zum Bereitstellen der Ausgangsspannung ($V_{out}$) und einem zweiten Ende (18) verbunden ist;
**dadurch gekennzeichnet, dass** er ferner mindestens einen komplementären Schalter (28) umfasst, der direkt zwischen Enden (16; 18) eines jeweiligen Paars aus erster (12A) und zweiter (12B) piezoelektrischer Anordnung verbunden ist, wobei die Enden (16; 18), die über einen jeweiligen komplementären Schalter (28) direkt miteinander verbunden sind, mit einer gleichen jeweiligen Schaltbrücke (30; 40) verbunden sind, wobei jeder komplementäre Schalter (28) nur mit den Enden (16; 18) des jeweiligen Paars aus erster (12A) und zweiter (12B) piezoelektrischer Anordnung verbunden ist, und
dass der Wandler (10) einerseits keine direkte Verbindung zwischen jedem komplementären Schalter (28) und einem jeweiligen Anschluss (34) zum Anlegen der Eingangsspannung ($V_{in}$) und andererseits keine direkte Verbindung zwischen jedem komplementären Schalter (28) und einem jeweiligen Anschluss (44) zum Bereitstellen der Ausgangsspannung ($V_{out}$) aufweist.

**2.** Wandler (10) nach Anspruch 1, wobei der Wandler (10) zwei komplementäre Schalter (28) umfasst, wobei ein erster komplementärer Schalter (28) direkt zwischen den ersten Enden (16) eines jeweiligen Paars aus erster (12A) und zweiter (12B) piezoelektrischer Anordnung verbunden ist, wobei die ersten Enden (16) mit der ersten Schaltbrücke (30) verbunden sind, und ein zweiter komplementärer Schalter (28) direkt zwischen die zweiten Enden (18) eines jeweiligen Paars aus erster (12A) und zweiter (12B) piezoelektrischer Anordnung verbunden ist, wobei die zweiten Enden (18) mit der zweiten Schaltbrücke (40) verbunden sind.

**3.** System (10) nach einem der vorherigen Ansprüche, wobei der Stromwandler (10) geeignet ist, um die Eingangsspannung ($V_{in}$) in mehrere verschiedene Ausgangsspannungen ($V_{out\_j}$) umzuwandeln, und
für jede jeweilige Ausgangsspannung ($V_{out\_j}$) Folgendes umfasst:

+ eine jeweilige zweite Schaltbrücke (40);
+ ein jeweiliges Paar aus erster (12A) und zweiter (12B) piezoelektrischer Anordnung.

4. Wandler (10) nach einem der vorherigen Ansprüche, wobei jede piezoelektrische Anordnung (12A, 12B) aus einer der Ausgestaltungen aus der Gruppe besteht, die aus Folgenden besteht: einem einzelnen piezoelektrischen Element (15); mehreren in Reihe verbundenen piezoelektrischen Elementen (15); mehreren parallel verbundenen piezoelektrischen Elementen (15); und einer Anordnung von mehreren parallelen piezoelektrischen Zweigen, wobei jeder Zweig ein oder mehrere in Reihe verbundene piezoelektrische Elemente (15) umfasst.

5. Wandler (10) nach einem der vorherigen Ansprüche, wobei jeder erste Schaltzweig (32) zwischen zwei Anschlüssen (34) zum Anlegen der Eingangsspannung ($V_{in}$) verbunden ist und mindestens zwei erste Schalter (36) umfasst, die in Reihe verbunden und an einem ersten Mittelpunkt (38) miteinander verbunden sind, wobei jeder erste Mittelpunkt (38) dann mit einem jeweiligen ersten Ende (16) verbunden ist.

6. Wandler (10) nach einem der vorherigen Ansprüche, wobei jeder zweite Schaltzweig (42) zwischen zwei Anschlüssen (44) zum Bereitstellen einer jeweiligen Ausgangsspannung ($V_{out}$) verbunden ist und mindestens zwei zweite Schalter (46) umfasst, die in Reihe verbunden und an einem zweiten Mittelpunkt (48) miteinander verbunden sind, wobei jeder zweite Mittelpunkt (48) dann mit einem jeweiligen zweiten Ende (18) verbunden ist.

7. Elektronisches System zur Stromumwandlung (5), umfassend einen Stromwandler (10) und eine elektronische Vorrichtung (20) zum Ansteuern des Stromwandlers (10), **dadurch gekennzeichnet, dass** der Stromwandler (10) gemäß einem der vorherigen Ansprüche ist.

8. System (5) nach Anspruch 7, wobei die elektronische Steuervorrichtung (20) konfiguriert ist, um während eines jeweiligen Resonanzzyklus der piezoelektrischen Anordnungen (12A, 12B) ein Schalten jedes der Schalter (36, 46) zu befehlen, um Phasen (II, IV, VI) mit im Wesentlichen konstanter Spannung an den piezoelektrischen Anordnungen (12A, 12B) und Phasen (I, III, V) mit im Wesentlichen konstanter Last an den piezoelektrischen Anordnungen (12A, 12B) abzuwechseln; wobei eine im Wesentlichen konstante Spannung einer Spannungsänderung von weniger als 20 % der Eingangs- oder Ausgangsspannung des Wandlers (10) entspricht; und wobei eine im Wesentlichen konstante Last einem Austausch einer Last mit außerhalb entspricht, der weniger als 10 % der Last beträgt, die mit außerhalb ausgetauscht worden wäre, wenn die Spannung konstant gehalten worden wäre.

9. System (5) nach Anspruch 8, wobei die elektronische Steuervorrichtung (20) ferner konfiguriert ist, um in mindestens einer Phase (II, IV, VI) mit im Wesentlichen konstanter Spannung mindestens einen jeweiligen komplementären Schalter (28) in die geschlossene Position zu befehlen.

10. System (5) nach Anspruch 8 oder 9, wobei die elektronische Steuervorrichtung (20) konfiguriert ist, um während jeder Phase (I, III, V) mit im Wesentlichen konstanter Last gleichzeitig höchstens einen jeweiligen der Schalter (36A, 46A) in die geschlossene Position zu schalten, die direkt mit der ersten piezoelektrischen Anordnung (12A) verbunden sind, und höchstens einen jeweiligen der Schalter (36B, 46B), die direkt mit der zweiten piezoelektrischen Anordnung (12B) verbunden sind, und in der offenen Position alle anderen Schalter (36, 46) der ersten und zweiten Schaltzweige (32, 42).

11. System (5) nach den Ansprüchen 9 und 10, wobei in Abwesenheit der Steuerung eines jeweiligen komplementären Schalters (28) in die geschlossene Position während einer jeweiligen Phase (II, IV, VI) mit im Wesentlichen konstanter Spannung der Wert ($V_a$, $V_b$, $V_c$) der Spannung während der Phase (II, IV, VI) mit im Wesentlichen konstanter Spannung aus der Gruppe von Werten ausgewählt ist, die aus folgendem besteht: Differenz ($V_{in}$ - $V_{out}$) zwischen dem Wert der Eingangsspannung ($V_{in}$) und dem der Ausgangsspannung ($V_{out}$); Differenz ($V_{out}$ - $V_{in}$) zwischen dem Wert der Ausgangsspannung ($V_{out}$) und dem der Eingangsspannung ($V_{in}$); Summe ($V_{in}$ + $V_{out}$) der Werte der Eingangs-spannung ($V_{in}$) und der Ausgangsspannung ($V_{out}$); und das Gegenteil der Summe ($-V_{in}$ $-V_{out}$) der Werte der Eingangsspannung ($V_{in}$) und der Ausgangsspannung ($V_{out}$); und
mit Befehlen mindestens eines jeweiligen komplementären Schalters (28) in eine geschlossene Position während einer jeweiligen Phase (II, IV, VI) mit im Wesentlichen konstanter Spannung, wobei die Gruppe von Werten ferner Folgendes umfasst: Wert der Eingangsspannung ($V_{in}$); entgegengesetzt ($-V_{in}$) zu dem Wert der Eingangsspannung ($V_{in}$); Wert der Ausgangsspannung ($V_{out}$); entgegengesetzt ($-V_{out}$) zu dem Wert der Ausgangsspannung ($V_{out}$); und Nullwert.

12. System (5) nach Anspruch 11, wobei die Gruppe von Werten den Wert der Eingangsspannung ($V_{in}$) und das Gegenteil

(-V$_{in}$) des Werts der Eingangsspannung (V$_{in}$) umfasst, wenn der Wandler (10) einen jeweiligen komplementären Schalter (28) umfasst, der direkt zwischen die zweiten Enden (18) eines jeweiligen Paars aus erster (12A) und zweiter (12B) piezoelektrischer Anordnung verbunden ist, wobei die zweiten Enden (18) mit der zweiten Schaltbrücke (40) verbunden sind;

die Gruppe von Werten den Wert der Ausgangsspannung (V$_{out}$) und das Gegenteil (-V$_{out}$) des Werts der Ausgangsspannung (V$_{out}$) umfasst, wenn der Wandler (10) einen jeweiligen komplementären Schalter (28) umfasst, der direkt zwischen den ersten Enden (16) eines jeweiligen Paars aus erster (12A) und zweiter (12B) piezoelektrischer Anordnung verbunden ist, wobei die ersten Enden (16) mit der ersten Schaltbrücke (30) verbunden sind;
die genannte Gruppe von Werten den Wert Null enthält, wenn der Wandler (10) nach Anspruch 2 ist.

13. Steuerungsverfahren eines Stromwandlers (10), wobei der Wandler (10) nach einem der Ansprüche 1 bis 9 ist, wobei das Verfahren von einer elektronischen Steuervorrichtung (20) durchgeführt wird und während eines jeweiligen Resonanzzyklus der piezoelektrischen Anordnungen (12A, 12B) den Befehl eines Schaltens jedes der Schalter (36, 46) umfasst, um Phasen (II, IV, VI) mit im Wesentlichen konstanter Spannung an den Klemmen der piezoelektrischen Anordnungen (12A, 12B) und Phasen (I, III, V) mit im Wesentlichen konstanter Last an den piezoelektrischen Anordnungen (12A, 12B) abzuwechseln; wobei eine im Wesentlichen konstante Spannung einer Spannungsänderung von weniger als 20 % der Eingangs- oder Ausgangsspannung des Wandlers (10) entspricht; und wobei eine im Wesentlichen konstante Last einem Austausch einer Last mit außerhalb entspricht, der weniger als 10 % der Last beträgt, die mit außerhalb ausgetauscht worden wäre, wenn die Spannung konstant gehalten worden wäre,

**dadurch gekennzeichnet, dass** während mindestens einer Phase (II, IV, VI) mit im Wesentlichen konstanter Spannung mindestens ein jeweiliger komplementärer Schalter (28) in die geschlossene Position gesteuert wird, und
dass der Wandler (10) einerseits keine direkte Verbindung zwischen jedem komplementären Schalter (28) und einem jeweiligen Anschluss (34) zum Anlegen der Eingangsspannung (V$_{in}$) und andererseits keine direkte Verbindung zwischen jedem komplementären Schalter (28) und einem jeweiligen Anschluss (44) zum Bereitstellen der Ausgangsspannung (V$_{out}$) aufweist.

14. Verfahren nach Anspruch 13, wobei während jeder Phase (I, III, V) mit im Wesentlichen konstanter Last gleichzeitig höchstens ein jeweiliger der Schalter (36A, 46A) in die geschlossene Position verbunden wird, die direkt mit der ersten piezoelektrischen Anordnung (12A) verbunden sind, und höchstens ein jeweiliger der Schalter (36B, 46B), die direkt mit der zweiten piezoelektrischen Anordnung (12B) verbunden sind, und in die offene Position alle anderen Schalter (36, 46) der ersten und zweiten Schaltzweige (32, 42).

## Claims

1. An electrical energy converter (10) able to convert an input voltage (V$_{in}$) to at least one output voltage (V$_{out}$), the converter (10) comprising:

   - at least one pair of first (12A) and second (12B) piezoelectric assemblies, each piezoelectric assembly (12A,12B) including at least one piezoelectric element (15),
   - a first switching bridge (30) including two first switching branches (32), each first switching branch (32) including at least one first switch (36);
   - at least one second switching bridge (40) including two second switching branches (42), each second switching branch (42) including at least one second switch (46);
   each piezoelectric assembly (12A,12B) including a first end (16) connected to the first switching bridge (30) and a second end (18) connected to the second switching bridge (40);
   each first switch (36) being connected between an input voltage (V$_{in}$) application terminal (34) and a respective first end (16);
   each second switch (46) being connected between an output voltage (V$_{out}$) supply terminal (44) and a respective second end (18); and
   **characterized in that** at least one complementary switch (28) connected directly between the ends (16; 18) of a respective pair of first (12A) and second (12B) piezoelectric assemblies, said ends (16; 18) being connected directly to each other via a respective complementary switch (28) being connected to a same respective switching bridge (30; 40), each complementary switch (28) being connected only to the ends (16; 18) of the respective pair of first (12A) and second (12B) piezoelectric assemblies, and
**in that** the converter is devoid of a direct connection between each complementary switch (28) and a respective input voltage ($V_{in}$) application terminal (34) on the one hand, and devoid of a direct connection between each complementary switch (28) and a respective output voltage ($V_{out}$) supply terminal (44) on the other hand.

2. The converter (10) according to claim 1, wherein the converter (10) comprises two complementary switches (28), a first complementary switch (28) being connected directly between first ends (16) of a respective pair of first (12A) and second (12B) piezoelectric assemblies, said first ends (16) being connected to the first switching bridge (30), and a second complementary switch (28) being connected directly between second ends (18) of a respective pair of first (12A) and second (12B) piezoelectric assemblies, said second ends (18) being connected to the second switching bridge (40).

3. The converter (10) according to any one of the preceding claims, wherein the electrical energy converter (10) is able to convert the input voltage ($V_{in}$) into a plurality of distinct output voltages ($V_{out\_i}$), and includes for each respective output voltage ($V_{out\_i}$):

   + a respective second switching bridge (40);
   + a respective pair of first (12A) and second (12B) piezoelectric assemblies.

4. The converter (10) according to any one of the preceding claims, wherein each piezoelectric assembly (12A, 12B) is constituted according to one of the constitutions among the group consisting of: a single piezoelectric element (15); a plurality of piezoelectric elements (15) connected in series; a plurality of piezoelectric elements (15) connected in parallel; and an arrangement of a plurality of parallel piezoelectric branches, each branch including one or more piezoelectric elements (15) connected in series.

5. The converter (10) according to any one of the preceding claims, wherein each first switching branch (32) is connected between two input voltage ($V_{in}$) application terminals (34) and includes at least two first switches (36) connected in series and connected together at a first midpoint (38), each first midpoint (38) then being connected to a respective first end (16).

6. The converter (10) according to any one of the preceding claims, wherein each second switching branch (42) is connected between two respective output voltage ($V_{out}$) supply terminals (44) and includes at least two second switches (46) connected in series and connected together at a second midpoint (48), each second midpoint (48) then being connected to a respective second end (18).

7. An electronic electrical energy conversion system (5) comprising an electrical energy converter (10) and an electronic control device (20) for controlling the electrical energy converter (10),
**characterized in that** the electrical energy converter (10) is according to any one of the preceding claims.

8. The system (5) according to claim 7, wherein the electronic control device (20) is configured to control, during a respective resonance cycle of the piezoelectric assemblies (12A, 12B), a switching of each of the switches (36, 46) to alternate substantially constant voltage phases (II, IV, VI) at the terminals of the piezoelectric assemblies (12A,12B) and substantially constant load phases (I, III, V) at said piezoelectric assemblies (12A, 12B), the substantially constant voltage corresponding to a voltage variation of less than 20% of the input or output voltage of the converter (10), and the substantially constant load corresponding to an exchange of a load with the outside which is less than 10% of the load that would have been exchanged with the outside if the voltage had been kept constant.

9. The system (5) according to claim 8, wherein the electronic control device (20) is further configured to, during at least one substantially constant voltage phase (II, IV, VI), control at least one respective complementary switch (28) to the closed position.

10. The system (5) according to claim 8 or 9, wherein the electronic control device (20) is configured to, during each substantially constant load phase (I, III, V), simultaneously control to the closed position at most one respective switch among the switches (36A, 46A) connected directly to the first piezoelectric assembly (12A) and at most one respective switch among the switches (36B, 46B) connected directly to the second piezoelectric assembly (12B), and in the open position all the other switches (36, 46) of the first and second switching branches (32, 42).

11. The system (5) according to claims 9 and 10, wherein, in the absence of controlling a respective complementary switch (28) in the closed position during a respective substantially constant voltage phase (II, IV, VI), the value ($V_a$, $V_b$, $V_c$) of the voltage during the substantially constant voltage phase (II, IV, VI) is selected from among the group of values consisting of: difference ($V_{in}$ - $V_{out}$) between the value of the input voltage ($V_{in}$) and that of the output voltage ($V_{out}$); difference ($V_{out}$ - $V_{in}$) between the value of the output voltage ($V_{out}$) and that of the input voltage($V_{in}$); sum ($V_{in}$ + $V_{out}$) of the values of the input ($V_{in}$) and output ($V_{out}$) voltages; and opposite (-$V_{in}$ - $V_{out}$) of the sum of the values of the input ($V_{in}$) and output ($V_{out}$) voltages; and

with the control of at least one respective complementary switch (28) in the closed position during a respective substantially constant voltage phase (II, IV, VI), said group of values further includes: value of the input voltage ($V_{in}$); opposite (-$V_{in}$) of the value of the input voltage ($V_{in}$); value of the output voltage ($V_{out}$); opposite (-$V_{out}$) of the value of the output voltage ($V_{out}$); and zero value.

12. The system (5) according to claim 11, wherein said group of values includes the value of the input voltage ($V_{in}$) and the opposite (-$V_{in}$) of the value of the input voltage ($V_{in}$) if the converter (10) comprises a respective complementary switch (28) connected directly between the second ends (18) of a respective pair of first (12A) and second (12B) piezoelectric assemblies, said second ends (18) being connected to the second switching bridge (40);

said group of values includes the value of the output voltage ($V_{out}$) and the opposite (-$V_{out}$) of the value of the output voltage ($V_{out}$) if the converter (10) comprises a respective complementary switch (28) connected directly between the first ends (16) of a respective pair of first (12A) and second (12B) piezoelectric assemblies, said first ends (16) being connected to the first switching bridge (30);

said group of values includes the value zero if the converter (10) is according to claim 2.

13. A method for controlling an electrical energy converter (10), the converter (10) being according to any one of claims 1 to 9, the method being implemented by an electronic control device (20) and comprising the control, during a respective resonance cycle of the piezoelectric assemblies (12A, 12B), of a switching of each of the switches (36, 46) to alternate substantially constant voltage phases (II, IV, VI) at the terminals of the piezoelectric assemblies (12A,12B) and substantially constant load phases (I, III, V) at said piezoelectric assemblies (12A,12B), the substantially constant voltage corresponding to a voltage variation of less than 20% of the input or output voltage of the converter (10), and the substantially constant load corresponding to an exchange of a load with the outside which is less than 10% of the load that would have been exchanged with the outside if the voltage had been kept constant,

characterized in that, during at least one substantially constant voltage phase (II, IV, VI), at least one respective complementary switch (28) is controlled to the closed position, and

in that the converter is devoid of a direct connection between each complementary switch (28) and a respective input voltage ($V_{in}$) application terminal (34) on the one hand, and devoid of a direct connection between each complementary switch (28) and a respective output voltage ($V_{out}$) supply terminal (44) on the other hand.

14. The method according to claim 13, wherein during each substantially constant load phase (I, III, V), at most one respective switch from among the switches (36A, 46A) connected directly to the first piezoelectric assembly (12A) and at most one respective switch from among the switches (36B, 46B) connected directly to the second piezoelectric assembly (12B) are controlled to the closed position at the same time, and all other switches (36, 46) of the first and second switching branches (32, 42) are controlled to the open position.

FIG.1

**FIG.2**

**FIG.3**

FIG.4

**FIG.5**

FIG.6

EP 4 191 853 B1

FIG.7

FIG.8

FIG.9

FIG.10

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2017012556 A1
- US 2013169198 A1
- CN 102522492 A
- FR 3086471 A1
- FR 3086472 A1
- FR 2107345

**Littérature non-brevet citée dans la description**

- **BENJAMIN POLLET**. *Convertisseurs DC-DC piézoélectrique avec stockage provisoire d'énergie sous forme mécanique*